# EUROPEAN PATENT APPLICATION

(11) **EP 3 116 261 A1**
(43) Date of publication of application: **11.01.2017**
(21) Application number: 14887092.6
(22) Date of filing: 24.03.2014
(51) Int. Cl.: H04W 28/06

(54) **METHOD FOR TRANSMITTING PHYSICAL LAYER DATA AND DATA TRANSMISSION DEVICE**

(71) Applicant: Huawei Technologies Co. Ltd., Shenzhen, Guangdong 518129 (CN)
(72) Inventor: WANG, Jueping, Shenzhen Guangdong 518129 (CN); ZHANG, Si, Shenzhen Guangdong 518129 (CN); ZOU, Zhiqiang, Shenzhen Guangdong 518129 (CN); JIANG, Yajun, Shenzhen Guangdong 518129 (CN); GONG, Xiaonian, Shenzhen Guangdong 518129 (CN)
(74) Representative: Körber, Martin Hans
(86) International application number: PCT/CN2014/073948
(87) International publication number: WO 2015/143602

(57) **Abstract**

Embodiments of the present invention provide a physical-layer data transmission method and a data transmission device, which can reduce limitations imposed by limited transmission bandwidth resources on transmission of physical-layer data inside a base station. The method includes: determining a target bit width of physical-layer data, where the target bit width is N bits; determining to-be-transmitted data whose bit width is N bits, where numerical values of all or some of bits in the to-be-transmitted data are numerical values extracted successively from a nonzero most significant bit to a less significant bit of the physical-layer data; and sending the to-be-transmitted data to a peer end. In the embodiments of the present invention, by performing bit width conversion on physical-layer data, a data rate is reduced, which can effectively reduce limitations imposed by limited transmission bandwidth resources on transmission of physical-layer data inside a base station, improve data transmission efficiency, and enhance user experience.

## Description

### TECHNICAL FIELD

The present invention relates to the field of wireless communication, and in particular, to a physical-layer data transmission method and a data transmission device.

### BACKGROUND

A Long Term Evolution (LTE, Long Term Evolution) system is long-term evolution of the Universal Mobile Telecommunications System (UMTS, Universal Mobile Telecommunications System) technical standard defined by the 3rd Generation Partnership Project (3GPP, The 3rd Generation Partnership Project) organization. Key transmission technologies such as orthogonal frequency division multiplexing (OFDM, Orthogonal Frequency Division Multiplexing) and multiple-input multiple-output (MIMO, Multi-input Multi-output) are introduced into the LTE system, which significantly increases spectral efficiency and a data transmission rate.

In the LTE system, when a base station processes physical-layer data, the physical-layer data needs to be transmitted between functional units of a same base station or between different base stations over a data transmission channel, where the data transmission channel may be a backplane or an optical cable inside a base station, or may be a fiber and a microwave inside a base station or between base stations, or the like. Such data transmission channels are not only used to transmit the foregoing physical-layer data, but may also be used to transmit other types of data. Therefore, bandwidth resources of a data transmission channel are rather limited. However, an LTE system is a wideband system, and imposes a relatively high bandwidth requirement on a physical-layer data transmission channel inside a base station or between base stations. Therefore, the limited bandwidth resources of the data transmission channel often cause limitations on transmission of physical-layer data inside a base station or between base stations. Especially when a data traffic volume is large, limited bandwidth may lead to data congestion, and result in discarding of data corresponding to some users, decrease of data transmission efficiency, and poor user experience.

### SUMMARY

Embodiments of the present invention provide a physical-layer data transmission method that can reduce limitations imposed by limited transmission bandwidth resources on transmission of physical-layer data inside a base station.

According to a first aspect, a physical-layer data transmission method is provided, including: determining, by a transmit end, a target bit width of physical-layer data, where the target bit width is N bits and the target bit width is less than an actual bit width of the physical-layer data; determining, by the transmit end, to-be-transmitted data whose bit width is N bits, where numerical values of all or some of bits in the to-be-transmitted data are numerical values extracted successively from a nonzero most significant bit to a less significant bit of the physical-layer data; and sending, by the transmit end, the to-be-transmitted data to a receive end.

With reference to the first aspect, in a first implementation manner of the first aspect, the determining, by the transmit end, to-be-transmitted data whose bit width is N bits includes: determining that a sign bit of the physical-layer data is a most significant bit of the to-be-transmitted data; and when i, a quantity of bits from the nonzero most significant bit to a least significant bit in the physical-layer data is greater than or equal to N-1, determining that numerical values of N-1 bits extracted successively from the nonzero most significant bit to a less significant bit of the physical-layer data are numerical values of a second most significant bit to a least significant bit of the to-be-transmitted data; or when i, a quantity of bits from the nonzero most significant bit to a least significant bit in the physical-layer data is less than N-1, determining that numerical values of i bits extracted successively from the nonzero most significant bit to a less significant bit of the physical-layer data are numerical values of a second most significant bit to a less significant bit of the to-be-transmitted data, and determining that numerical values of N-1-i less significant bits are 0.

With reference to the first aspect and the foregoing implementation manner thereof, in a second implementation manner of the first aspect, after the determining, by the transmit end, to-be-transmitted data whose bit width is N bits, the method further includes: converting, according to a location of the nonzero most significant bit of the physical-layer data, subsequent data of the physical-layer data into data whose bit width is N bits, where numerical values of all or some of bits in the data whose bit width is N bits are numerical values of bits extracted from the subsequent data.

With reference to the first aspect and the foregoing implementation manner thereof, in a third implementation manner of the first aspect, before the determining, by the transmit end, to-be-transmitted data whose bit width is N bits, the method further includes: determining bit sequence information of the nonzero most significant bit of the physical-layer data, where the bit sequence information is used to indicate that the nonzero most significant bit of the physical-layer data is the (i-1)th bit of the physical-layer data.

With reference to the first aspect and the foregoing implementation manner thereof, in a fourth implementation manner of the first aspect, after the determining, by the transmit end, to-be-transmitted data whose bit width is N bits, the method further includes: converting, according to the bit sequence information, subsequent data of the physical-layer data into data whose bit width is N bits, where numerical values of all or some of bits in the data whose bit width is N bits are numerical values of bits extracted from the subsequent data.

With reference to the first aspect and the foregoing implementation manner thereof, in a fifth implementation manner of the first aspect, the determining, by a transmit end, a target bit width of physical-layer data includes: determining, according to a correspondence between preset condition information and a candidate target bit width, that a candidate target bit width corresponding to condition information of the physical-layer data is a candidate target bit width of the physical-layer data; determining a data traffic volume of data, into which the physical-layer data is converted, with the candidate target bit width; and determining, when the data traffic volume is less than a target traffic volume, that the candidate target bit width is the target bit width, where the target traffic volume is less than or equal to a maximum data traffic volume allowed by a transmission channel of the physical-layer data.

With reference to the first aspect and the foregoing implementation manner thereof, in a sixth implementation manner of the first aspect, after the determining a data traffic volume of data, into which the physical-layer data is converted, with the candidate target bit width, the method further includes: reducing the candidate target bit width of the physical-layer data according to a predetermined range when the data traffic volume is greater than the target traffic volume; and when a data traffic volume of data, into which the physical-layer data is converted, with a reduced candidate target bit width is less than the target traffic volume, and when the reduced candidate target bit width is greater than or equal to a guaranteed bit width, determining that the reduced candidate target bit width is the target bit width, where the guaranteed bit width is a minimum bit width with which the physical-layer data can be normally transmitted and parsed.

With reference to the first aspect and the foregoing implementation manner thereof, in a seventh implementation manner of the first aspect, after the determining, by the transmit end, to-be-transmitted data whose bit width is N bits, the method further includes: sending an initial bit width and the bit sequence information of the physical-layer data to the receive end.

With reference to the first aspect and the foregoing implementation manner thereof, in an eighth implementation manner of the first aspect, the condition information that is used to determine the target bit width includes at least one of the following: a modulation scheme, a quantity of antennas, a MIMO manner, and channel measurement information.

According to a second aspect, a physical-layer data transmission method is provided, including: receiving, by a receive end, to-be-restored data sent by a transmit end, where an actual bit width of the to-be-restored data is N bits, the to-be-restored data is data obtained from bit width conversion of physical-layer data, and numerical values of all or some of bits in the to-be-restored data are numerical values extracted successively from a nonzero most significant bit to a less significant bit of the physical-layer data; receiving, by the receive end, an initial bit width of the physical-layer data, where the initial bit width is sent by the transmit end and is M bits, and N is less than M; and determining, by the receive end, restored data whose bit width is M bits, where numerical values of some of bits in the restored data are numerical values of bits extracted successively from a second most significant bit to a less significant bit of the to-be-restored data.

With reference to the second aspect, in a first implementation manner of the second aspect, before the determining, by the receive end, restored data whose bit width is M bits, the method further includes: receiving bit sequence information of the physical-layer data, where the bit sequence information is sent by the transmit end and is used to indicate that the nonzero most significant bit of the physical-layer data is the (i-1)th bit of the physical-layer data; and according to the bit sequence information, determining i, the a quantity of bits from a nonzero most significant bit to a least significant bit in the restored data, so that the restored data whose bit width is M bits includes i bits of valid data, where numerical values of the valid data are the numerical values of the bits extracted successively from the second most significant bit to the less significant bit of the to-be-restored data.

With reference to the second aspect and the foregoing implementation manner thereof, in a second implementation manner of the second aspect, before the determining, by the receive end, restored data whose bit width is M bits, the method further includes: determining i, a quantity of bits from a nonzero most significant bit to a least significant bit in the restored data, so that the restored data whose bit width is M bits includes i bits of valid data, where numerical values of the valid data are the numerical values of the bits extracted successively from the second most significant bit to the less significant bit of the to-be-restored data.

With reference to the second aspect and the foregoing implementation manner thereof, in a third implementation manner of the second aspect, the determining, by the receive end, restored data whose bit width is M bits includes: determining that a sign bit of the to-be-restored data is a most significant bit of the restored data; and when i, the quantity of bits from the nonzero most significant bit to the least significant bit in the restored data, is greater than N-1, a quantity of bits from the second most significant bit to a least significant bit in the to-be-restored data, determining that numerical values of N-1 bits extracted successively from the second most significant bit to a less significant bit of the to-be-restored data are numerical values of the nonzero most significant bit to a less significant bit of the restored data, and determining that numerical values of i-(N-1) less significant bits are 0; or when i, the quantity of bits from the nonzero most significant bit to the least significant bit in the restored data, is less than or equal to N-1, a quantity of bits from the second most significant bit to a least significant bit in the to-be-restored data, determining that numerical values of i bits extracted successively from the second most significant bit to a less significant bit of the to-be-restored data are numerical values of the nonzero most significant bit to the least significant bit of the restored data.

With reference to the second aspect and the foregoing implementation manner thereof, in a fourth implementation manner of the second aspect, after the determining that a sign bit of the to-be-restored data is a most significant bit of the restored data, the method further includes: determining that numerical values of bits from the most significant bit to the nonzero most significant bit of the restored data are 0.

With reference to the second aspect and the foregoing implementation manner thereof, in a fifth implementation manner of the second aspect, after the determining, by the receive end, restored data whose bit width is M bits, the method further includes: converting, according to the initial bit width and the bit sequence information, subsequent data of the to-be-restored data into data whose bit width is M bits, where numerical values of some of bits in the data whose bit width is M bits are numerical values of bits extracted successively from a second most significant bit to a less significant bit of the subsequent data.

According to a third aspect, a data transmission device is provided, including: a determining unit, configured to determine a target bit width of physical-layer data, where the target bit width is N bits and the target bit width is less than an actual bit width of the physical-layer data, where the determining unit is further configured to determine to-be-transmitted data whose bit width is N bits, where numerical values of all or some of bits in the to-be-transmitted data are numerical values extracted successively from a nonzero most significant bit to a less significant bit of the physical-layer data; and a sending unit, configured to send the to-be-transmitted data to a receive end.

With reference to the third aspect, in a first implementation manner of the third aspect, that the determining unit is configured to determine to-be-transmitted data whose bit width is N bits includes: determining that a sign bit of the physical-layer data is a most significant bit of the to-be-transmitted data; and when i, a quantity of bits from the nonzero most significant bit to a least significant bit in the physical-layer data is greater than or equal to N-1, determining that numerical values of N-1 bits extracted successively from the nonzero most significant bit to a less significant bit of the physical-layer data are numerical values of a second most significant bit to a least significant bit of the to-be-transmitted data; or when i, a quantity of bits from the nonzero most significant bit to a least significant bit in the physical-layer data is less than N-1, determining that numerical values of i bits extracted successively from the nonzero most significant bit to a less significant bit of the physical-layer data are numerical values of a second most significant bit to a less significant bit of the to-be-transmitted data, and determining that numerical values of N-1-i less significant bits are 0.

With reference to the third aspect and the foregoing implementation manner thereof, in a second implementation manner of the third aspect, the determining unit is further configured to: convert, according to a location of the nonzero most significant bit of the physical-layer data, subsequent data of the physical-layer data into data whose bit width is N bits, where numerical values of all or some of bits in the data whose bit width is N bits are numerical values of bits extracted from the subsequent data.

With reference to the third aspect and the foregoing implementation manner thereof, in a third implementation manner of the third aspect, the determining unit is further configured to determine bit sequence information of the nonzero most significant bit of the physical-layer data, where the bit sequence information is used to indicate that the nonzero most significant bit of the physical-layer data is the (i-1)th bit of the physical-layer data.

With reference to the third aspect and the foregoing implementation manner thereof, in a fourth implementation manner of the third aspect, the determining unit is further configured to: convert, according to the bit sequence information, subsequent data of the physical-layer data into data whose bit width is N bits, where numerical values of all or some of bits in the data whose bit width is N bits are numerical values of bits extracted from the subsequent data.

With reference to the third aspect and the foregoing implementation manner thereof, in a fifth implementation manner of the third aspect, that the determining unit is configured to determine a target bit width of physical-layer data includes: determining, according to a correspondence between preset condition information and a candidate target bit width, that a candidate target bit width corresponding to condition information of the physical-layer data is a candidate target bit width of the physical-layer data; determining a data traffic volume of data, into which the physical-layer data is converted, with the candidate target bit width; and determining, when the data traffic volume is less than a target traffic volume, that the candidate target bit width is the target bit width, where the target traffic volume is less than or equal to a maximum data traffic volume allowed by a transmission channel of the physical-layer data.

With reference to the third aspect and the foregoing implementation manner thereof, in a sixth implementation manner of the third aspect, the determining unit is further configured to: reduce the candidate target bit width of the physical-layer data according to a predetermined range when the data traffic volume is greater than the target traffic volume; and when a data traffic volume of data, into which the physical-layer data is converted, with a reduced candidate target bit width is less than the target traffic volume, and when the reduced candidate target bit width is greater than or equal to a guaranteed bit width, determine that the reduced candidate target bit width is the target bit width, where the guaranteed bit width is a minimum bit width with which the physical-layer data can be normally transmitted and parsed.

With reference to the third aspect and the foregoing implementation manner thereof, in a seventh implementation manner of the third aspect, the sending unit is further configured to send an initial bit width and the bit sequence information of the physical-layer data to a receive end.

With reference to the third aspect and the foregoing implementation manner thereof, in an eighth implementation manner of the third aspect, the condition information that is used to determine the target bit width includes at least one of the following: a modulation scheme, a quantity of antennas, a MIMO manner, and channel measurement information.

According to a fourth aspect, a data transmission device is provided, including: a receiving unit, configured to receive to-be-restored data sent by a transmit end, where an actual bit width of the to-be-restored data is N bits, the to-be-restored data is data obtained from bit width conversion of physical-layer data, and numerical values of all or some of bits in the to-be-restored data are numerical values extracted successively from a nonzero most significant bit to a less significant bit of the physical-layer data, where the receiving unit is further configured to receive an initial bit width of the physical-layer data, where the initial bit width is sent by the transmit end and is M bits, and N is less than M; and a determining unit, configured to determine restored data whose bit width is M bits, where numerical values of some of bits in the restored data are numerical values of bits extracted successively from a second most significant bit to a less significant bit of the to-be-restored data.

With reference to the fourth aspect, in a first implementation manner of the fourth aspect, the determining unit is further configured to: receive bit sequence information of the physical-layer data by using the receiving unit, where the bit sequence information is sent by the transmit end and is used to indicate that the nonzero most significant bit of the physical-layer data is the (i-1)th bit of the physical-layer data; and according to the bit sequence information, determine i, a quantity of bits from a nonzero most significant bit to a least significant bit in the restored data, so that the restored data whose bit width is M bits includes i bits of valid data, where numerical values of the valid data are the numerical values of the bits extracted successively from the second most significant bit to the less significant bit of the to-be-restored data.

With reference to the fourth aspect and the foregoing implementation manner thereof, in a second implementation manner of the fourth aspect, the determining unit is further configured to: determine i, a quantity of bits from a nonzero most significant bit to a least significant bit in the restored data, so that the restored data whose bit width is M bits includes i bits of valid data, where numerical values of the valid data are the numerical values of the bits extracted successively from the second most significant bit to the less significant bit of the to-be-restored data.

With reference to the fourth aspect and the foregoing implementation manner thereof, in a third implementation manner of the fourth aspect, that a determining unit is configured to determine restored data whose bit width is M bits includes: determining that a sign bit of the to-be-restored data is a most significant bit of the restored data; and when i, the quantity of bits from the nonzero most significant bit to the least significant bit in the restored data, is greater than N-1, a quantity of bits from the second most significant bit to a least significant bit in the to-be-restored data, determining that numerical values of N-1 bits extracted successively from the second most significant bit to a less significant bit of the to-be-restored data are numerical values of the nonzero most significant bit to a less significant bit of the restored data, and determining that numerical values of i-(N-1) less significant bits are 0; or when i, the quantity of bits from the nonzero most significant bit to the least significant bit in the restored data, is less than or equal to N-1, a quantity of bits from the second most significant bit to a least significant bit in the to-be-restored data, determining that numerical values of i bits extracted successively from the second most significant bit to a less significant bit of the to-be-restored data are numerical values of the nonzero most significant bit to the least significant bit of the restored data.

With reference to the fourth aspect and the foregoing implementation manner thereof, in a fourth implementation manner of the fourth aspect, the determining unit is further configured to determine that numerical values of bits from the most significant bit to the nonzero most significant bit of the restored data are 0.

With reference to the fourth aspect and the foregoing implementation manner thereof, in a fifth implementation manner of the fourth aspect, the determining unit is further configured to convert, according to the initial bit width and the bit sequence information, subsequent data of the to-be-restored data into data whose bit width is M bits, where numerical values of some of bits in the data whose bit width is M bits are numerical values of bits extracted successively from a second most significant bit to a less significant bit of the subsequent data.

In the embodiments of the present invention, a target bit width of physical-layer data that needs to be transmitted is determined, and the physical-layer data is transmitted after a bit width of the physical-layer data is reduced to the target bit width, thereby reducing bandwidth required for transmitting the physical-layer data. By using the technical solution provided by the embodiments of the present invention to transmit the physical-layer data, a bandwidth requirement for a data transmission channel of a system is lowered, which can effectively reduce limitations imposed by limited bandwidth resources of a data transmission channel on transmission of the physical-layer data inside a base station or between base stations, improve transmission efficiency of the physical-layer data, and enhance user experience. In addition, when the technical solution provided by the embodiments of the present invention is used to convert a bit width of physical-layer data, numerical values of bits extracted from a nonzero most significant bit to a less significant bit of the physical-layer data are retained; therefore, valid data in the physical-layer data is retained as much as possible, and data distortion is reduced.

### BRIEF DESCRIPTION OF DRAWINGS

To describe the technical solutions in the embodiments of the present invention more clearly, the following briefly describes the accompanying drawings required for describing the embodiments of the present invention. Apparently, the accompanying drawings in the following description show merely some embodiments of the present invention, and a person of ordinary skill in the art may still derive other drawings from these accompanying drawings without creative efforts.
FIG. 1 is a schematic block diagram of one application scenario according to an embodiment of the present invention;
FIG. 2 is a schematic block diagram of another application scenario according to an embodiment of the present invention;
FIG. 3 is a flowchart of a physical-layer data transmission method according to an embodiment of the present invention;
FIG. 4 is a flowchart of a physical-layer data transmission method according to another embodiment of the present invention;
FIG. 5 is a flowchart of data bit width conversion according to an embodiment of the present invention;
FIG 6 is a schematic diagram of bits in data bit width conversion according to an embodiment of the present invention;
FIG 7 is a schematic diagram of bits in data bit width conversion according to another embodiment of the present invention;
FIG 8 is a flowchart of data bit width restoration according to an embodiment of the present invention;
FIG 9 is a schematic diagram of bits in data bit width restoration according to an embodiment of the present invention;
FIG 10 is a schematic diagram of bits in data bit width restoration according to another embodiment of the present invention;
FIG 11 is a schematic diagram of a data combination principle according to an embodiment of the present invention;
FIG. 12 is a schematic block diagram of a data transmission device according to an embodiment of the present invention;
FIG. 13 is a schematic block diagram of a data transmission device according to an embodiment of the present invention;
FIG. 14 is a schematic block diagram of a data transmission device according to another embodiment of the present invention; and
FIG. 15 is a schematic block diagram of a data transmission device according to another embodiment of the present invention.

### DESCRIPTION OF EMBODIMENTS

The following clearly and completely describes the technical solutions in the embodiments of the present invention with reference to the accompanying drawings in the embodiments of the present invention. Apparently, the described embodiments are a part rather than all of the embodiments of the present invention. All other embodiments obtained by a person of ordinary skill in the art based on the embodiments of the present invention without creative efforts shall fall within the protection scope of the present invention.

The technical solutions of the present invention may be applied to various communications systems, such as: a Global System for Mobile Communications (GSM, Global System of Mobile Communication) system, a Code Division Multiple Access (CDMA, Code Division Multiple Access) system, a Wideband Code Division Multiple Access (WCDMA, Wideband Code Division Multiple Access Wireless) system, a general packet radio service (GPRS, General Packet Radio Service), and a Long Term Evolution (LTE, Long Term Evolution) system.

In the embodiments of the present invention, a user equipment (UE, User Equipment), also referred to as a mobile terminal (Mobile Terminal), a mobile user equipment, and the like, may communicate with one or more core networks by using a radio access network (for example, RAN, Radio Access Network). The user equipment may be a mobile terminal, such as a mobile phone (or referred to as a "cellular" phone) and a computer with a mobile terminal. For example, the user equipment may be a portable, pocket-sized, handheld, computer built-in, or in-vehicle mobile apparatus, which exchanges language and/or data with the radio access network.

In the embodiments of the present invention, a base station may be a base transceiver station (BTS, Base Transceiver Station) in GSM or CDMA, or may be a NodeB (NodeB) in WCDMA, or may be an evolved NodeB (eNB or e-NodeB, evolutional Node B) in LTE, which is not limited in the present invention. However, for ease of description, the following embodiments are described by using an eNB as an example.

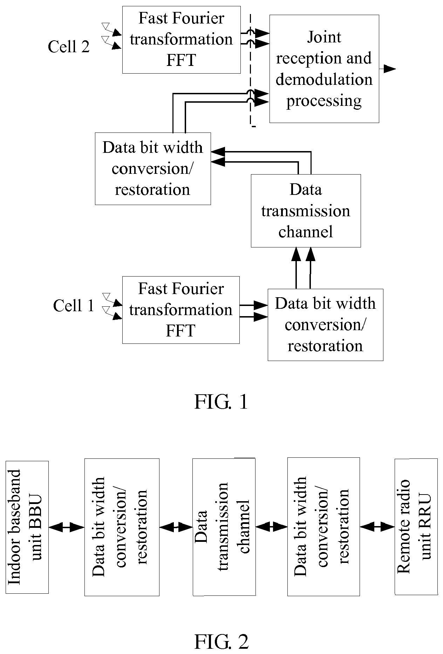

FIG. 1 is a schematic block diagram of one application scenario according to an embodiment of the present invention.

FIG. 1 shows one application scenario according to an embodiment of the present invention. In this scenario, the embodiment of the present invention is applicable to an LTE data transmission channel between different cells of a same base station. Signaling and data may be exchanged between different cells of a same base station. Especially in a cell coordination scenario in an LTE system, signaling and data are exchanged between cells more frequently. As shown in FIG. 1, cell 1 and cell 2 are coordinating cells of each other. Data of cell 1 may be transmitted to cell 2, and cell 2 performs joint reception processing on data of cell 1 and cell 2 to obtain better reception performance, where cell 1 and cell 2 may be managed by a same control device of a base station, or may be managed by different control devices of a base station.

Specifically, the data of cell 1 may undergo discrete fast Fourier transformation (FFT, Fast Fourier Transformation) first to be transformed from a time domain to a frequency domain, then a data bit width converting/restoring module on a cell 1 side reduces a bit width of the data of cell 1, that is, reduces a data rate, and then the data is transmitted to a cell 2 side through a data transmission channel from cell 1 to cell 2. a data converting/restoring module located on the cell 2 side restores a bit width of the data to an initial bit width first, that is, restores the data rate, and then joint reception and demodulation processing is performed on the data together with the data of cell 2. The data transmission channel from cell 1 to cell 2 may include a backplane and an optical cable inside a device that controls both cell 1 and cell 2, and may also include a fiber and a microwave between a device that controls cell 1 and a device that controls cell 2, and the like. Such transmission bandwidth resources are limited.

It should be understood that the joint reception and demodulation processing may also be performed by cell 1. That is, the data of cell 2 after bit width conversion is sent to cell 1 through a data transmission channel, and cell 1 performs bit width restoration on the received data of cell 2 and then performs joint reception and demodulation processing on the data together with the data of cell 1.

In addition, upon receiving the data that is sent by cell 1 and has undergone bit width conversion, cell 2 may not perform bit width restoration on the data of cell 1. Instead, the data converting/restoring module converts local data of cell 2 into data of a bit width the same as the data bit width of cell 1, and then performs joint reception and demodulation processing on the data of cell 1 and cell 2.

In this scenario, a module that is used to perform data bit width conversion/restoration may be a software functional module or may be a hardware apparatus module, and is deployed inside a base station that controls both cell 1 and cell 2. Specifically, the deployment may be performed for cell 1 and cell 2 separately, that is, two data bit width converting/restoring modules may be deployed for the two cells inside the base station that controls both cell 1 and cell 2, or only one data bit width converting/restoring module is deployed and shared by the two cells. The present invention is not limited thereto.

Still further, when performing bit width conversion on physical-layer data, cell 1 and cell 2 may determine a target bit width for the bit width conversion performed on the data by considering factors such as a modulation scheme, a codec type and a channel transmission condition of the data, and by considering a restoration ability of the data that has undergone bit width conversion.

It should be noted that the data bit width in the embodiment of the present invention refers to a quantity of bits that are transmitted in parallel in the data, and the data rate refers to a quantity of bits transmitted per second. It is easy to understand that data bit width conversion/restoration may lead to data rate conversion/restoration, and a correspondence exists between the two. A larger data bit width indicates a higher data rate; a smaller data bit width indicates a lower data rate. Therefore, in the embodiment of the present invention, the data bit width conversion/restoration may be equivalent to data rate conversion/restoration. FIG. 2 is a schematic block diagram of another application scenario according to an embodiment of the present invention.

FIG. 2 shows another application scenario according to an embodiment of the present invention. In a remote radio scenario, a baseband unit (BBU, Base Band Unit) and a remote radio unit (RRU, Remote Radio Unit) of a base station may transmit physical-layer data through a data transmission channel such as a fiber or radio. In such a scenario, transmission bandwidth for the physical-layer data is also limited. In addition, because the BBU is sometimes far away from the RRU, and a transmission distance may be up to tens of kilometers, a problem that the limited transmission bandwidth for the physical-layer data between the BBU and the RRU affects data transmission becomes more acute.

As shown in FIG. 2, a data bit width converting/restoring module reduces a data bit width (reduces a data rate) of physical-layer data of a BBU, and then the data is transmitted to an RRU side through a transmission channel. The RRU side may use the data bit width converting/restoring module to restore the data to an initial bit width, a data rate is also restored to an original data rate, and then the RRU performs corresponding processing on received data. Conversely, the data bit width converting/restoring module may also reduce a data bit width of physical-layer data of the RRU, then the data is transmitted to the BBU, and the BBU restores the data to an initial bit width and then performs further processing.

It should be understood that the embodiment of the present invention is also applicable to various networking topologies specified in the Common Public Radio Interface (CPRI, Common Public Radio Interface) protocol, such as a star network and a chain network. The embodiment of the present invention is not limited thereto.

In this scenario, a module that is used to perform data bit width conversion/restoration may be a software functional module or may be a hardware apparatus module. The data bit width converting/restoring module may be deployed inside the BBU and the RRU, and independently deployed on a BBU side and an RRU side. Specifically, two data bit width converting/restoring modules may be integrated separately as software modules into control modules of the BBU and the RRU, or may serve as two independent hardware apparatuses that are electrically connected to the BBU and the RRU separately. The present invention is not limited thereto.

In addition, a data transmission channel for transmitting physical-layer data between two different base stations may be a fiber, optical cable, or radio transmission channel that connects the two base stations. Bandwidth resources of the data transmission channel between two base stations are also limited. The embodiment of the present invention is also applicable to transmission of physical-layer data between two different base stations. For example, base station 1 performs bit width conversion on physical-layer data to be sent, and sends the data to base station 2, and base station 2 performs data bit width restoration correspondingly, which is similar to a physical-layer data processing process inside a base station and is not described herein again.

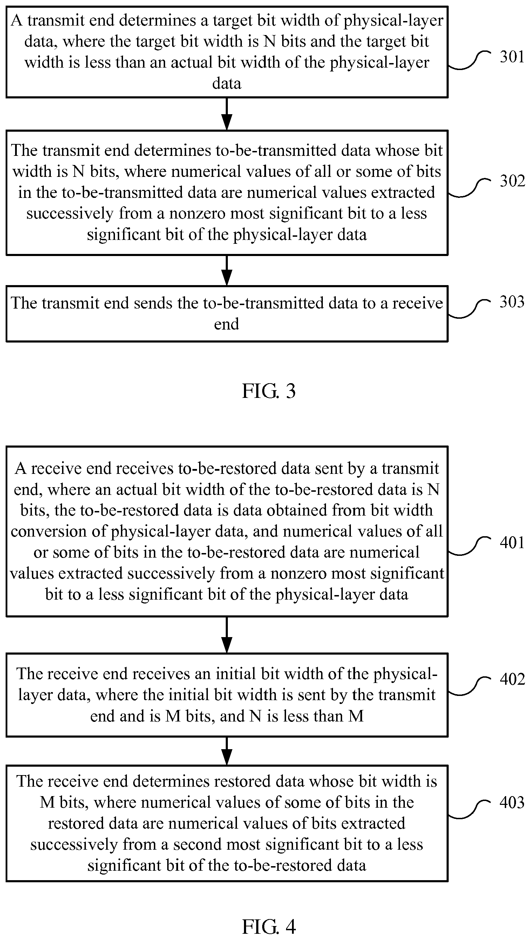

FIG. 3 is a flowchart of a physical-layer data transmission method according to an embodiment of the present invention. The transmission method is applicable to transmission of physical-layer data inside a base station or between base stations.

301. A transmit end determines a target bit width of physical-layer data, where the target bit width is N bits and the target bit width is less than an actual bit width of the physical-layer data.

302. The transmit end determines to-be-transmitted data whose bit width is N bits, where numerical values of all or some of bits in the to-be-transmitted data are numerical values extracted successively from a nonzero most significant bit to a less significant bit of the physical-layer data.

303. The transmit end sends the to-be-transmitted data to a receive end.

In the embodiment of the present invention, a target bit width of physical-layer data that needs to be transmitted is determined, and the physical-layer data is transmitted after a bit width of the physical-layer data is reduced to the target bit width, thereby reducing bandwidth required for transmitting the physical-layer data; a bandwidth requirement for a data transmission channel of a system is lowered, which can effectively reduce limitations imposed by limited bandwidth resources of a data transmission channel on transmission of the physical-layer data inside a base station or between base stations, improve transmission efficiency of the physical-layer data, and enhance user experience. In addition, during bit width conversion, numerical values of bits extracted from a nonzero most significant bit to a less significant bit of the physical-layer data are retained; therefore, valid data in the physical-layer data is retained as many as possible, and data distortion is reduced.

It should be understood that an entity for executing the embodiment of the present invention may be referred to as a transmit end, that is, an end that executes bit width conversion and data sending, and an end that receives data may be referred to as a receive end. The transmit end and the receive end are relative concepts, and actual execution entities may be interchanged. Using the application scenario in FIG. 1 as an example, the transmit end may be a corresponding control device of cell 1, the receive end may be a corresponding control device of cell 2, and vice versa. For another example, in the application scenario in FIG. 2, the transmit end may be the BBU, the receive end may be the RRU, and vice versa.

Optionally, in an embodiment, step 302 may include: determining that a sign bit of the physical-layer data is a most significant bit of the to-be-transmitted data; when i, a quantity of bits from the nonzero most significant bit to a least significant bit in the physical-layer data is greater than or equal to N-1, determining that numerical values of N-1 bits extracted successively from the nonzero most significant bit to a less significant bit of the physical-layer data are numerical values of a second most significant bit to a least significant bit of the to-be-transmitted data; or when i, a quantity of bits from the nonzero most significant bit to a least significant bit in the physical-layer data is less than N-1, determining that numerical values of i bits extracted successively from the nonzero most significant bit to a less significant bit of the physical-layer data are numerical values of a second most significant bit to a less significant bit of the to-be-transmitted data, and determining that numerical values of N-1-i less significant bits are 0.

That is, after the target bit width N into which the physical-layer data needs to be converted is determined, the physical-layer data with an initial bit width may be converted into to-be-transmitted data whose bit width is N bits, so as to facilitate transmission. Specifically, physical-layer data generally includes a sign bit, and the sign bit that is a most significant bit of the physical-layer data may be determined as a most significant bit of the to-be-transmitted data. Subsequently, i, the quantity of bits from the nonzero most significant bit to the least significant bit in the physical-layer data, and N-1 are compared.. That is, it is necessary to determine whether a quantity of valid bits that are used for carrying data and are included in the physical-layer data is enough to implement bit width conversion with the target bit width being N bits, or in other words, to determine whether 0 needs to be added as a filler in the bit width conversion.

Specifically, an example is given to describe a scenario in which i, the quantity of bits from the nonzero most significant bit to the least significant bit in the physical-layer data is greater than or equal to N-1. It is assumed that the initial bit width of the physical-layer data is 16 bits, that the nonzero most significant bit of the physical-layer data is the 10th bit, and that the least significant bit is the 0th bit. That is, the quantity of bits from the nonzero most significant bit to the least significant bit is i=11. A predetermined target bit width is N=8 bits. After the sign bit that is a most significant bit of at the most significant bit is excluded, N-1=7, where i is greater than N-1, indicating that the quantity of valid bits that are used for carrying data and are included in the physical-layer data is enough to implement bit width conversion with the target bit width being 8 bits. Therefore, during the bit width conversion, it may be determined that the numerical values of 7 bits extracted successively from the nonzero most significant bit to a less significant bit of the physical-layer data are the numerical values of the second most significant bit to the least significant bit of the to-be-transmitted data.

An example is given to describe a scenario in which i, the quantity of bits from the nonzero most significant bit to the least significant bit in the physical-layer data is less than N-1. It is assumed that the initial bit width of the physical-layer data is 16 bits, that the nonzero most significant bit of the physical-layer data is the 5th bit, and that the least significant bit is the 0th bit. That is, the quantity of bits from the nonzero most significant bit to the least significant bit is i=6. A predetermined target bit width is N=8 bits. After the sign bit that is a most significant bit of at the most significant bit is excluded, N-1=7, where i is less than N-1, indicating that the quantity of valid bits that are used for carrying data and are included in the physical-layer data is not enough to implement bit width conversion with the target bit width being 8 bits. Therefore, during the bit width conversion, zeros need to be added as fillers while the valid bits of the physical-layer data are extracted. Specifically, it may be determined that the numerical values of 6 bits extracted successively from the nonzero most significant bit to the least significant bit of the physical-layer data are the numerical values of 6 bits from the second most significant bit to a less significant bit of the to-be-transmitted data, and the numerical value of the 1 remaining least significant bit of the to-be-transmitted data is filled with 0.

Optionally, in another embodiment, before the determining to-be-transmitted data whose bit width is N bits, the method may further include: determining bit sequence information of the nonzero most significant bit of the physical-layer data, where i, the quantity of bits from the nonzero most significant bit to the least significant bit in the physical-layer data may be determined according to the bit sequence information, where the bit sequence information is used to indicate that the nonzero most significant bit is the (i-1)th bit of the physical-layer data (a bit sequence of the physical-layer data starts with the 0th bit). For determining the bit sequence information of the nonzero most significant bit of the physical-layer data, the input physical-layer data may be temporarily stored after the input physical-layer data is received, and then data detection is performed on the physical-layer data to determine which bit is the nonzero most significant bit of the physical-layer data. Physical-layer data generally includes a sign bit. That is, the data detection is performed to detect the bits of the physical-layer data from the second most significant bit to a less significant bit of the physical-layer data, and determine a bit sequence (which bit) of a first nonzero bit that is detected. For example, the physical-layer data is 00101, the most significant bit (the 4th bit from the right) is a sign bit, the least significant bit (rightmost) is the 0th bit, and the nonzero most significant bit is the 2nd bit. The bit sequence information is information that is used to indicate a location of the nonzero most significant bit. A correspondence between the location of the nonzero most significant bit and the bit sequence information may be predefined. For example, bit sequence information 0000 indicates that the nonzero most significant bit is the 0th bit, bit sequence information 0001 indicates that the nonzero most significant bit is the 1st bit, bit sequence information 0010 indicates that the nonzero most significant bit is the 2nd bit, and the like.

Optionally, in another embodiment, the determining a target bit width of physical-layer data includes: determining, according to a correspondence between preset condition information and a candidate target bit width, that a candidate target bit width corresponding to condition information of the physical-layer data is a candidate target bit width of the physical-layer data; determining a data traffic volume of data, into which the physical-layer data is converted, with the candidate target bit width; and determining, when the data traffic volume is less than a target traffic volume, that the candidate target bit width is the target bit width, where the target traffic volume is less than or equal to a maximum data traffic volume allowed by a transmission channel of the physical-layer data.

The condition information that is used to determine the target bit width includes but is not limited to one or more of the following: a modulation scheme of the physical-layer data, a quantity of antennas at a base station, a service type (such as full buffering and burst), a MIMO manner (transmit and receive diversity, multiplexing, and the like), channel measurement information (such as a channel signal-to-noise ratio and channel measurement power), a guaranteed bit width, and the like. It should be understood that the condition information considered for determining the target bit width is not limited to those enumerated above, and may further include other factors that can affect generation, transmission and parsing of the physical-layer data, which is not limited in the present invention. Optionally, before the target bit width of the physical-layer data is determined, a correspondence between one or more items of the foregoing condition information and the candidate target bit width may be preset. For example, a correspondence between the modulation scheme, the quantity of antennas, the guaranteed bit width and the candidate target bit width may be preset. Then, a corresponding candidate target bit width may be determined according to the foregoing types of condition information of the physical-layer data, where the guaranteed bit width is a minimum bit width with which the physical-layer data can be normally transmitted and parsed.

The bit width of the physical-layer data is converted dynamically by using the foregoing condition information. A data transmission rate may be adjusted dynamically according to a current data transmission condition of a system. Especially, the target bit width may be determined comprehensively according to system modulation information or service requirement information, which can reduce the data bit width on a precondition of satisfying service performance requirements of the system.

In addition, in view of a granularity of data bit width conversion, the target bit width may also be used as a target bit width of multiple pieces of data before and/or after the physical-layer data when the target bit width of the physical-layer data is determined. A size of the granularity may be adjusted according to a buffer depth of a bit width converting module. For example, if the buffer depth of the bit width converting module is preset to 100 pieces of data, the bit width converting module may temporarily store 100 pieces of data at a time. For any of the 100 pieces of data such as the foregoing physical-layer data, a target bit width may be determined according to the foregoing method, and the target bit width is used as a target bit width of the 100 pieces of data. For another example, the buffer depth of the bit width converting module may also be set to 1 piece of data, that is, a target bit width is determined for each piece of data. A finer granularity may achieve higher precision in determining the candidate target bit width and a data traffic volume, and a coarser granularity may increase a processing speed and reduce resource overhead.

After the candidate target bit width is determined elementarily, the data traffic volume after the conversion into the candidate target bit width and the target traffic volume may be compared to determine whether the candidate target bit width meets a requirement, where the target traffic volume may be a maximum data traffic volume that can be carried by a physical-layer data transmission channel, and may be determined according to a transmission bandwidth limit of the physical-layer data.

Optionally, the data traffic volume may be estimated in advance according to the candidate target bit width, so as to determine the data traffic volume of data, into which the physical-layer data is converted, with the candidate target bit width. Specifically, it may be defined that the data traffic volume is an amount of data that passes through a physical-layer data transmission channel within a period. That is, the determining of the data traffic volume may be performed only on the physical-layer data converted into the candidate target bit width, or may be performed on multiple pieces of data before and/or after the physical-layer data converted into the candidate target bit width. In addition, other data may be transmitted in parallel with the physical-layer data converted into the candidate target bit width, so the determining of the data traffic volume may also be performed on both the physical-layer data converted into the candidate target bit width and parallel data thereof.

As for comparing the data traffic volume after the conversion into the candidate target bit width and the target traffic volume, the following comparing results and subsequent processing may exist:
Optionally, one comparing result and subsequent processing are: when the data traffic volume after the conversion into the candidate target bit width is less than the target traffic volume, it is determined that the candidate target bit width is the target bit width, where the target traffic volume is determined according to transmission bandwidth of the physical-layer data. Because the determined correspondence between the candidate target bit width and the condition information may include a guaranteed bit width, the candidate target bit width determined according to the correspondence is greater than the guaranteed bit width. That is, the current candidate target bit width meets a requirement, and may be determined as the target bit width.

Optionally, another determining result and subsequent processing process are: the candidate target bit width of the physical-layer data is reduced according to a predetermined range when the data traffic volume after the conversion into the candidate target bit width is greater than the target traffic volume; it is determined whether a data traffic volume determined according to a reduced candidate target bit width is less than the target traffic volume, and it is ensured that the reduced candidate target bit width is greater than the guaranteed bit width; and when the data traffic volume determined according to the reduced candidate target bit width is less than the target traffic volume, and the reduced candidate target bit width is greater than or equal to the guaranteed bit width, it is determined that the reduced candidate target bit width is the target bit width.

With this determining result, if bit width conversion is performed on the physical-layer data according to the candidate target bit width, the data traffic volume obtained after the conversion exceeds the maximum data traffic volume allowed by the data transmission channel, that is, the target traffic volume. Therefore, the candidate target bit width needs to be reduced. For example, during reduction of the candidate target bit width, a candidate target bit width of a low-priority user may be reduced according to a range of 1 bit that is agreed upon in advance. Then, a data traffic volume of the physical-layer data converted into a reduced candidate target bit width may be determined. That is, the data traffic volume is re-determined according to the reduced candidate target bit width, and the re-determined data traffic volume and the target traffic volume is compared. If the re-determined data traffic volume is still greater than the target traffic volume, the bit width is further reduced until a re-determined data traffic volume is less than the target traffic volume, and in this case, a current candidate target bit width may be determined as the target bit width.

If the current candidate target bit width is already reduced to the guaranteed bit width but the data traffic volume is still greater than the target traffic volume, alarm information may be sent, and another upper-layer functional unit in the base station performs further processing, for example, performs traffic suppression and resource scheduling, so as to relieve data transmission pressure on the physical-layer data transmission channel.

Optionally, still another determining result is that the data traffic volume is equal to the target traffic volume. A subsequent processing process in this case may be agreed upon in advance according to actual conditions. This determining result may be incorporated into the case in which the data traffic volume is greater than the target traffic volume, and may also be incorporated into the case in which the data traffic volume is less than the target traffic volume. Correspondingly, the subsequent processing process may be executed according to the subsequent processing process in either of the foregoing two cases as agreed upon in advance, which is not specially limited in the present invention.

Optionally, in another embodiment, after the determining to-be-transmitted data whose bit width is N bits, the method may further include: converting subsequent data of the physical-layer data into data whose bit width is N bits according to the target bit width and the bit sequence information. According to the granularity principle of data bit width conversion mentioned in the foregoing embodiment, the (candidate) target bit width determined for the physical-layer data may also be used as the (candidate) target bit width of multiple pieces of data before and/or after the physical-layer data. For example, the target bit width of the physical-layer data may be determined as the target bit width of subsequent 99 pieces of data. That is, the target bit width and the bit sequence information of the physical-layer data may be used as the target bit width and the bit sequence information of subsequent data for bit width conversion of subsequent data, thereby saving computing resources of the system. A quantity of pieces (that is, granularity) of subsequent data that uses the target bit width and the bit sequence information may be set according to a running status of the system. For example, when load of the system is light, the granularity may be reduced; when the load of the system is heavy, the granularity may be increased properly. A finer granularity may achieve higher precision in bit width conversion, and a coarser granularity may increase a processing speed and reduce resource overhead.

Optionally, in an embodiment, after the determining to-be-transmitted data whose bit width is N bits, the method may further include: sending an initial bit width and the bit sequence information of the physical-layer data to a receive end, so that the receive end restores the received to-be-transmitted data to data with the initial bit width according to the bit sequence information. After the data that has undergone bit width conversion is transmitted to the receive end, bit width restoration may be performed so that the data can be parsed by the receive end correctly. Therefore, when sending the to-be-transmitted data, a local end may also send the initial bit width and the bit sequence information of the physical-layer data together to the receive end to facilitate bit width restoration performed at the receive end.

In the embodiment of the present invention, a target bit width of physical-layer data that needs to be transmitted is determined, and the physical-layer data is transmitted after a bit width of the physical-layer data is reduced to the target bit width, thereby reducing bandwidth required for transmitting the physical-layer data; a bandwidth requirement for a data transmission channel of a system is lowered, which can effectively reduce limitations imposed by limited bandwidth resources of a data transmission channel on transmission of the physical-layer data inside a base station or between base stations, improve transmission efficiency of the physical-layer data, and enhance user experience. In addition, in the embodiment of the present invention, the target bit width is determined comprehensively according to system modulation information or service requirement information, which can reduce the data bit width on a precondition of satisfying service performance requirements of the system. Further in the embodiment of the present invention, by determining a nonzero most significant bit and determining a quantity of valid bits, as many valid bits as possible are retained when bit width conversion is performed, which can reduce data distortion caused by the bit width conversion as much as possible. In addition, by arbitrarily adjusting a granularity for processing the bit width conversion, the system can achieve, according to an actual running status, higher precision in the bit width conversion or achieve a higher processing speed and less resource overhead.

FIG. 4 is a flowchart of a physical-layer data transmission method according to another embodiment of the present invention.

401. A receive end receives to-be-restored data sent by a transmit end, where an actual bit width of the to-be-restored data is N bits, the to-be-restored data is data obtained from bit width conversion of physical-layer data, and numerical values of all or some of bits in the to-be-restored data are numerical values extracted successively from a nonzero most significant bit to a less significant bit of the physical-layer data.

402. The receive end receives an initial bit width of the physical-layer data, where the initial bit width is sent by the transmit end and is M bits, and N is less than M.

403. The receive end determines restored data whose bit width is M bits, where numerical values of some of bits in the restored data are numerical values of bits extracted successively from a second most significant bit to a less significant bit of the to-be-restored data.

In the embodiment of the present invention, by performing bit width conversion on physical-layer data, a data rate can be reduced during data transmission, and bit width restoration is performed at a receive end to restore data that has undergone the bit width conversion. By using the technical solution in the embodiment of the present invention to transmit the physical-layer data, a bandwidth requirement for a data transmission channel of a system is lowered, which can effectively reduce limitations imposed by limited bandwidth resources of a data transmission channel on transmission of the physical-layer data inside a base station or between base stations, improve transmission efficiency of the physical-layer data, and enhance user experience.

It should be understood that an entity for executing the embodiment of the present invention may be referred to as a receive end, that is, an end that executes data receiving and bit width restoration, and an end that performs data bit width conversion and data sending may be referred to as a transmit end. The transmit end and the receive end are relative concepts, and actual execution entities may be interchanged. Using the application scenario in FIG. 1 as an example, the receive end may be cell 1 and the transmit end may be cell 2, and vice versa. For another example, in the application scenario in FIG. 2, the receive end may be the BBU, and the transmit end may be the RRU, and vice versa.

It should be understood that the to-be-restored data received by the receive end and sent by the transmit end may be data obtained after the transmit end performs bit width conversion on the physical-layer data, and the bit width conversion method described in the embodiment shown in FIG. 3 may be applied. The data that has undergone bit width conversion may be referred to as to-be-transmitted data, and after being sent by the transmit end to the receive end, the to-be-transmitted data may be referred to as to-be-restored data. That is, the to-be-transmitted data and the to-be-restored data mentioned in the embodiment of the present invention may refer to a same object. The data obtained after the receive end performs bit width restoration on the to-be-restored data may be referred to as restored data. The restored data includes valid data, and numerical values of the valid data are the same as numerical values of some of bits of the to-be-restored data. It is easy to understand that the restored data may be not completely the same as the physical-layer data because the data has undergone two processing processes, that is, bit width conversion and bit width restoration.

Optionally, in an embodiment, before step 403, the method may further include: receiving bit sequence information of the physical-layer data, where the bit sequence information is sent by the transmit end and is used to indicate that the nonzero most significant bit of the physical-layer data is the (i-1)th bit of the physical-layer data; and according to the bit sequence information, determining i, a quantity of bits from a nonzero most significant bit to a least significant bit in the restored data, so that the restored data whose bit width is M bits includes i bits of valid data, where numerical values of the valid data are the numerical values of the bits extracted successively from the second most significant bit to the less significant bit of the to-be-restored data.

Specifically, when performing bit width conversion on the physical-layer data, the transmit end may determine bit sequence information of the nonzero most significant bit of the physical-layer data. For a detailed method for determining the bit sequence information, reference may be made to the related description in the embodiment shown in FIG. 3, and details are not described herein again.

Optionally, in an embodiment, before step 403, the method may further include: determining i, a quantity of bits from a nonzero most significant bit to a least significant bit in the restored data, so that the restored data whose bit width is M bits includes i bits of valid data, where numerical values of the valid data are the numerical values of the bits extracted successively from the second most significant bit to the less significant bit of the to-be-restored data. That is, after receiving the to-be-restored data, the receive end may directly determine a location of the nonzero most significant bit of the restored data that is restored from the to-be-restored data.

Optionally, in an embodiment, step 403 may include: determining that a sign bit of the to-be-restored data is a most significant bit of the restored data; and when i, the quantity of bits from the nonzero most significant bit to the least significant bit in the restored data, is greater than N-1, a quantity of bits from the second most significant bit to a least significant bit in the to-be-restored data, determining that numerical values of N-1 bits extracted successively from the second most significant bit to a less significant bit of the to-be-restored data are numerical values of the nonzero most significant bit to a less significant bit of the restored data, and determining that numerical values of i-(N-1) less significant bits are 0; or when i, the quantity of bits from the nonzero most significant bit to the least significant bit in the restored data, is less than or equal to N-1, a quantity of bits from the second most significant bit to a least significant bit in the to-be-restored data, determining that numerical values of i bits extracted successively from the second most significant bit to a less significant bit of the to-be-restored data are numerical values of the nonzero most significant bit to the least significant bit of the restored data.

For example, a bit width of the to-be-restored data is N=8 bits, the initial bit width is 16 bits, and the bit sequence information indicates that the nonzero most significant bit of the physical-layer data/restored data is the 10th bit. That is, the quantity of bits from the nonzero most significant bit to a less significant bit in the restored data is i=11, and i is greater than N-1. In this case, it may be determined that numerical values of 7 bits from the second most significant bit (the 6th bit) to the least significant bit (the 0th bit) of the to-be-restored data are numerical values of 7 bits from the nonzero most significant bit (the 10th bit) to a less significant bit (the 4th bit) of the restored data, and it may be determined that numerical values of the 4 least significant bits (from the 3rd bit to the 0th bit) of the restored data are 0.

For another example, a bit width of the to-be-restored data is N=8 bits, the initial bit width is 16 bits, and the bit sequence information indicates that the nonzero most significant bit of the physical-layer data/restored data is the 5th bit. That is, the quantity of bits from the nonzero most significant bit to a less significant bit in the restored data is i=6, and i is less than N-1. In this case, it may be determined that numerical values of 6 bits from the second most significant bit (the 6th bit) to a less significant bit (the 1st bit) of the to-be-restored data are numerical values of 6 bits from the nonzero most significant bit (the 5th bit) to the least significant bit (the 0th bit) of the restored data.

So far, in a subsequent bit width restoration process for the foregoing two determining results, the numerical values of the most significant bit and the bits from the nonzero most significant bit to the least significant bit of the restored data are determined, and it may be determined that numerical values of bits from the most significant bit (sign bit) to the nonzero most significant bit are 0, so as to complete the entire bit width restoration process and obtain the restored data whose bit width is M bits.

Optionally, in an embodiment, after step 403, the method may further include: converting subsequent data of the to-be-restored data into data whose bit width is M bits according to a target bit width and the bit sequence information. That is, a target bit width and the bit sequence information of the physical-layer data may be used as a target bit width and bit sequence information of subsequent to-be-restored data for performing bit width restoration on the subsequent to-be-restored data. A quantity of pieces of subsequent to-be-restored data that uses the target bit width and the bit sequence information may be set. For example, it is set that 99 pieces of subsequent to-be-restored data share the target bit width and the bit sequence information for performing bit width restoration. A granularity of data bit width restoration may be adjusted arbitrarily. A finer granularity may achieve higher precision in bit width restoration, and a coarser granularity may increase a processing speed and reduce resource overhead. The granularity may be adjusted by means of a buffer depth. For a detailed description of the granularity, reference may be made to the related content in the embodiment shown in FIG. 3, and details are not described herein again.

In addition, in an optional embodiment, after receiving the to-be-restored data sent by the transmit end, the receive end may, according to a system running status, service requirements, or the like, independently determine a bit width to which the to-be-restored data is to be restored, so as to facilitate bit width restoration.

In the embodiment of the present invention, by performing bit width conversion on physical-layer data, a data rate can be reduced during data transmission, and bit width restoration is performed at a receive end to restore data that has undergone the bit width conversion, which can effectively reduce limitations imposed by limited transmission bandwidth resources on transmission of physical-layer data inside a base station, thereby enhancing user experience.

Further in the embodiment of the present invention, by determining a nonzero most significant bit and determining a quantity of valid bits, as many valid bits as possible are retained when bit width restoration is performed, which can restore physical-layer data that has undergone bit width conversion and reduce data distortion as much as possible. In addition, by arbitrarily adjusting a granularity for processing bit width restoration, higher precision or a higher processing speed and less resource overhead can be achieved according to actual conditions. In addition, in the embodiment of the present invention, a target bit width is determined comprehensively according to system modulation information or service requirement information, which can reduce the data bit width on a precondition of satisfying service performance requirements of the system. Further in the embodiment of the present invention, by determining the nonzero most significant bit and determining the quantity of valid bits, as many valid bits as possible are retained when bit width conversion is performed, which can reduce data distortion caused by the bit width conversion as much as possible. In addition, by arbitrarily adjusting a granularity for processing the bit width conversion, the system can achieve, according to an actual running status, higher precision in the bit width conversion or achieve a higher processing speed and less resource overhead.

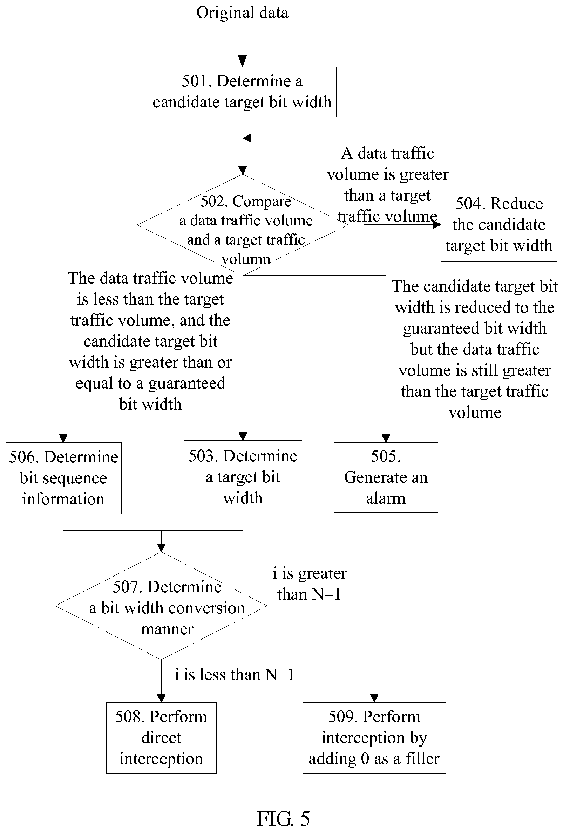

FIG. 5 is a flowchart of data bit width conversion according to an embodiment of the present invention.

501. Determine a candidate target bit width.

Multiple factors (condition information) need to be considered in determining a target bit width of physical-layer data, for example, a modulation scheme of the physical-layer data, a quantity of antennas at a base station, a service type (such as full buffering and burst), a MIMO manner (transmit and receive diversity, multiplexing, and the like), channel measurement information (such as a channel signal-to-noise ratio and channel measurement power), and a guaranteed bit width. It should be understood that the factors considered for determining the target bit width are not limited to those enumerated above, and may further include other factors that can affect generation, transmission and parsing of the physical-layer data.

Specifically, a correspondence between one or more of the foregoing factors and the target bit width may be preset. For example, a correspondence between the modulation scheme, a quantity of antennas, the guaranteed bit width and the target bit width may be preset. In determining the target bit width, the corresponding target bit width may be determined according to the foregoing several types of information, as detailed in Table 1:

**Table 1**

| Modulation scheme | Quantity of antennas | Guaranteed bit width | Target bit width |
|---|---|---|---|
| 64QAM | 2 antennas | 8bits | 10 |
| | 4 antennas | 8bits | 10 |
| | 8 antennas | 8bits | 10 |
| 16QAM | 2 antennas | 6bits | 8 |
| | 4 antennas | 6bits | 8 |
| | 8 antennas | 6bits | 8 |
| QPSK | 2 antennas | 4bits | 6 |
| | 4 antennas | 4bits | 6 |
| | 8 antennas | 4bits | 6 |

According to Table 1, the modulation scheme and the quantity of antennas may be determined according to site information of a base station. For example, if the modulation scheme of physical-layer data is 16QAM and the quantity of antennas at the base station is 8 antennas, it may be elementarily determined that the target bit width is 8 bits, that is, the target bit width is 8 bits. The candidate target bit width determined elementarily according to the foregoing several types of information may cause a traffic volume of data converted into the candidate target bit width to be greater than a target traffic volume. Therefore, the target bit width needs to be further determined by performing a next step.

502. Compare a data traffic volume with a target traffic volume.

The target traffic volume may be determined according to a data transmission bandwidth limit, and may be set to a maximum or relatively large traffic volume allowed by data transmission bandwidth. According to the candidate target bit width determined in step 501, the data traffic volume of the data converted into the candidate target bit width is determined, and the data traffic volume is compared with the target traffic volume. For a process of determining the data traffic volume of the data converted into the candidate target bit width, reference may be made to the embodiment corresponding to FIG. 4, and details are not described herein again.

503. Determine a target bit width.

When the data traffic volume determined according to the candidate target bit width is less than or equal to the target traffic volume, and the candidate target bit width is greater than or equal to the guaranteed bit width, it indicates that the candidate target bit width meets a requirement and may be determined as the target bit width. A case in which the data traffic volume is equal to the target traffic volume may be agreed upon according to actual conditions and incorporated into step 503 or incorporated into step 504.

504. Reduce the candidate target bit width.

When the data traffic volume determined according to the candidate target bit width is greater than the target traffic volume, it indicates that the data traffic volume already exceeds the data transmission bandwidth limit. In this case, the candidate target bit width needs to be reduced. An attempt may be made first to reduce a candidate target bit width of a low-priority user according to a small range. For example, the candidate target bit width of the low-priority user is reduced by 1 bit. Then, the process may return to step 502 to recalculate the data traffic volume and compare the data traffic volume with the target traffic volume again. If the data traffic volume is still greater than the target traffic volume, step 504 is further performed to reduce the bit width until the data traffic volume is less than the target traffic volume, and in this case, step 503 is performed in which a current candidate target bit width is determined as the target bit width; or until a current candidate target bit width is reduced to the guaranteed bit width, and in this case, step 505 is performed.

505. Generate an alarm.

If the candidate target bit width is already reduced to the guaranteed bit width in step 504 but the data traffic volume is still greater than the target traffic volume according to the determining in step 502, alarm information may be generated, and an upper-layer functional unit performs further processing, for example, performs traffic suppression and resource scheduling.

506. Determine bit sequence information.

This step may be performed in parallel with the foregoing step, and the bit sequence information of the physical-layer data needs to be determined at the same time when the target bit width is determined. Specifically, the input physical-layer data may be temporarily stored after the input physical-layer data is received, and then data detection is performed on the physical-layer data to determine which bit is a nonzero most significant bit of the physical-layer data. Physical-layer data generally includes a sign bit. That is, the data detection is performed to detect bits of the physical-layer data from a second most significant bit to a less significant bit of the physical-layer data, and determine a bit sequence (which bit) of a first nonzero bit that is detected. For example, the physical-layer data is 00101, a most significant bit (the 4th bit from the right) is a sign bit, a least significant bit (rightmost) is the 0th bit, and the nonzero most significant bit is the 2nd bit. The bit sequence information is information that is used to indicate a location of the nonzero most significant bit. A correspondence between the location of the nonzero most significant bit and the bit sequence information may be predefined, as described in Table 2:

**Table 2**

| Location of the nonzero most significant bit | Bit sequence information |
|---|---|
| 0^{th}bit | 0000 |
| 1^{st}bit | 0001 |
| 2^{ed} bit | 0010 |
| 3^{rd}bit | 0011 |
| 4^{th}bit | 0100 |
| 5^{th}bit | 0101 |
| 6^{th}bit | 0110 |
| 7^{th}bit | 0111 |
| 8^{th}bit | 1000 |
| 9^{th}bit | 1001 |
| 10^{th} bit | 1010 |
| 11^{th}bit | 1011 |
| 12^{th}bit | 1100 |
| 13^{th}bit | 1101 |
| 14^{th}bit | 1110 |

For example, bit sequence information 0000 indicates that the nonzero most significant bit is the 0th bit, bit sequence information 0001 indicates that the nonzero most significant bit is the 1^{st} bit, bit sequence information 0010 indicates that the nonzero most significant bit is the 2nd bit, and the like. It should be understood that a specific manner of representing the foregoing bit sequence information and the correspondence between the bit sequence information and the nonzero most significant bit may be predefined independently, and the present invention is not limited thereto.

In addition, a granularity of data bit width conversion may be adjusted by adjusting a buffer depth. For example, the buffer depth may be set to P pieces of data, and in this case, P pieces of data that are temporarily stored at a time determine a target bit width, where the physical-layer data may be any of the P pieces of data. The buffer depth may also be set to 1 piece of data, that is, a target bit width is determined for each piece of data. A finer granularity may achieve higher precision in the target bit width and the bit width conversion, and a coarser granularity may increase a processing speed and reduce resource overhead.

507. Determine a bit width conversion manner.

According to the target bit width determined in step 503 and the bit sequence information determined in step 506, a conversion manner of converting the physical-layer data into to-be-transmitted data with the target bit width may be determined, that is, a start point of data bit extraction and a quantity of bits to be extracted may be determined. Specifically, i, a quantity of bits from a nonzero most significant bit to a least significant bit in the physical-layer data, and N-1 needs to be compared. That is, it is necessary to determine whether a quantity of valid bits that are used for carrying data and are included in the physical-layer data is enough to implement bit width conversion with the target bit width being N bits, or in other words, to determine whether 0 needs to be added as a filler in the bit width conversion.

508. Perform direct extraction.

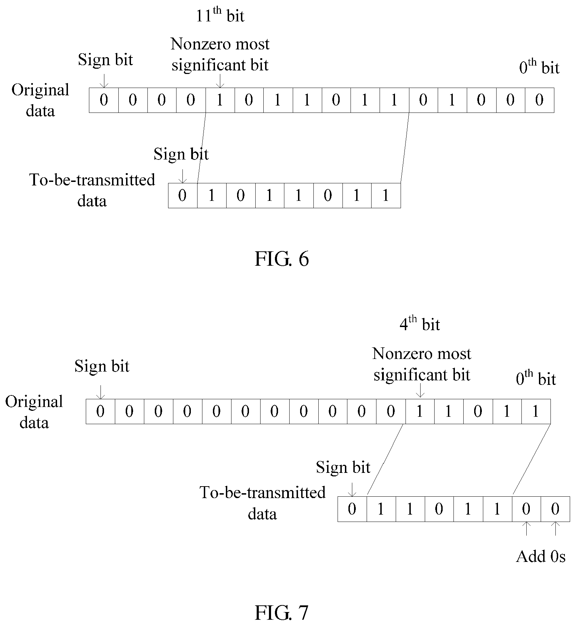

When i, the quantity of bits from the nonzero most significant bit to the least significant bit in the physical-layer data is greater than or equal to N-1, it is determined that numerical values of N-1 bits extracted successively from the nonzero most significant bit to a less significant bit of the physical-layer data are numerical values of a second most significant bit to a least significant bit of the to-be-transmitted data. Specifically, for example, as shown in FIG. 6, a bit width of the physical-layer data is 16 bits; specific numerical values are 0000101101101000; the nonzero most significant bit is the 11th bit, that is, the quantity of bits from the nonzero most significant bit to the least significant bit is i=12; the target bit width is N=8 bits; after a sign bit that is a most significant bit of in a most significant bit is excluded, N-1=7, and i is greater than N-1. It may be determined that the sign bit that is a most significant bit of in the most significant bit of the physical-layer data is a most significant bit of the to-be-transmitted data, and that numerical values 1011011 of 7 bits from the nonzero most significant bit to a less significant bit of the physical-layer data are numerical values of 7 bits from the second most significant bit to a less significant bit of the to-be-transmitted data.

It should be understood that, for ease of description, bit width conversion is described as bit extraction. In an actual application, the data bit width conversion may be implemented by shifting bits. That is, the data of the 7 bits from the nonzero most significant bit to the less significant bit is shifted leftward by 3 bits, and redundant bits are deleted, so as to form to-be-transmitted data that has undergone bit width conversion. Bit shift information may be determined according to bit sequence information, an initial bit width, and a target bit width.

509. Perform extraction by adding 0 as a filler.

When i, the quantity of bits from the nonzero most significant bit to the least significant bit in the physical-layer data is less than N-1, it is determined that numerical values of all i bits extracted successively from the nonzero most significant bit to a less significant bit of the physical-layer data are numerical values of a second most significant bit to a less significant bit of the to-be-transmitted data. Specifically, for example, as shown in FIG. 7, a bit width of the physical-layer data is 16 bits; specific numerical values are 0000000000011011; the nonzero most significant bit is the 4th bit, that is, the quantity of bits from the nonzero most significant bit to the least significant bit is i=5; the target bit width is N=8 bits; after a sign bit that is a most significant bit of in a most significant bit is excluded, N-1=7, and i is less than N-1. It may be determined that the sign bit that is a most significant bit of in the most significant bit of the physical-layer data is a most significant bit of the to-be-transmitted data, and that numerical values 11011 of i=5 bits from the nonzero most significant bit to a less significant bit of the physical-layer data are numerical values of 5 bits from the second most significant bit to a less significant bit of the to-be-transmitted data, and numerical values of the remaining two least significant bits are filled with 0.

It should be understood that, for ease of description, bit width conversion is described as bit extraction. In an actual application, the data bit width conversion may be implemented by shifting bits. That is, the data of the 5 bits from the nonzero most significant bit to the less significant bit is shifted leftward by 10 bits, remaining bits are deleted and two least significant bits are filled, so as to form to-be-transmitted data that has undergone bit width conversion. Bit shift information may be determined according to bit sequence information, an initial bit width, and a target bit width.

The bit sequence information in step 507 and initial bit width information of the physical-layer data may be transmitted together with the to-be-transmitted data to a receive end, so that the receive end performs bit width restoration according to the bit sequence information and the initial bit width information.

In the embodiment of the present invention, by performing bit width conversion on physical-layer data, a data rate is reduced, which can effectively reduce limitations imposed by limited transmission bandwidth resources on transmission of physical-layer data inside a base station, thereby enhancing user experience. In addition, by arbitrarily adjusting a granularity for processing the bit width conversion, higher precision in bit width conversion can be achieved or a higher processing speed and less resource overhead can be achieved according to actual conditions.

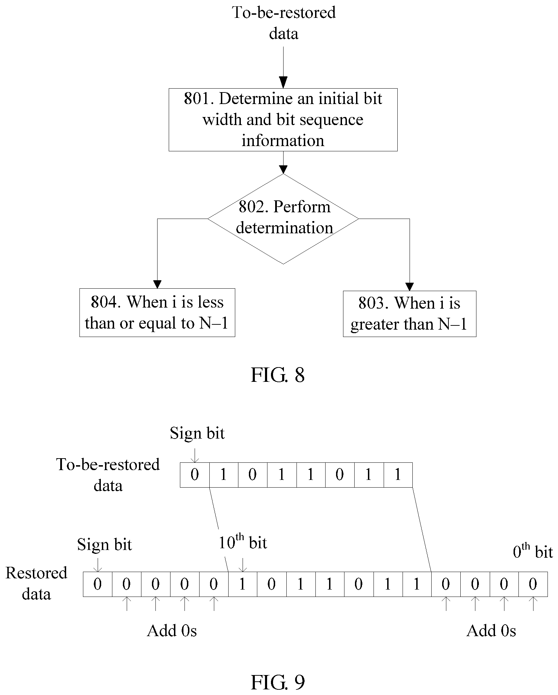

FIG. 8 is a flowchart of data bit width restoration according to an embodiment of the present invention.

801. Determine an initial bit width and bit sequence information of physical-layer data.

After receiving to-be-restored data sent by a transmit end, it can be determined that a bit width of the to-be-restored data is N bits. In addition, according to received information, an initial bit width being M bits and bit sequence information are determined. In addition, a receive end may independently determine an initial bit width to which data is to be restored and bit sequence information.

802. Determine a bit width restoration manner.

According to the initial bit width and the bit sequence information in step 801, a restoration manner of converting the to-be-restored data into restored data with the initial bit width may be determined. Specifically, i, a quantity of bits from a nonzero most significant bit to a least significant bit in the restored data needs to be determined according to the bit sequence information, and i and N-1, a quantity of bits from a second most significant bit to the least significant bit of the restored data needs to be compared.

803. A case in which i is greater than N-1:
When i, the quantity of bits from the nonzero most significant bit to the least significant bit in the restored data is greater than N-1, the quantity of bits from the second most significant bit to the least significant bit in the to-be-restored data, determine that numerical values of N-1 bits extracted successively from the second most significant bit to a less significant bit of the to-be-restored data are numerical values of the nonzero most significant bit to a less significant bit of the restored data, and determine that numerical values of i-(N-1) less significant bit are 0. Specifically, for example, as shown in FIG. 9, a bit width of to-be-restored data 01011011 is N=8 bits, an initial bit width is 16 bits, and the bit sequence information indicates that a nonzero most significant bit of the physical-layer data is the 10th bit. That is, the quantity of bits from the nonzero most significant bit to a less significant bit in the restored data is i=11, and i is greater than N-1. It may be determined that a sign bit that is a most significant bit of in a most significant bit of the to-be-restored data is a sign bit that is a most significant bit of in a most significant bit of the restored data. It may be determined that numerical values of 4 bits from the second most significant bit (the 14th bit) to a previous bit (the 11th bit) of the nonzero most significant bit of the restored data are 0; it may be determined that numerical values 1011011 of 7 bits from the second most significant bit to a less significant bit of the to-be-restored data are numerical values of 7 bits from the nonzero most significant bit to a less significant bit of the restored data, and it may be determined that numerical values of remaining 3 less significant bits (from the 2nd bit to the 0th bit) of the restored data are 0.

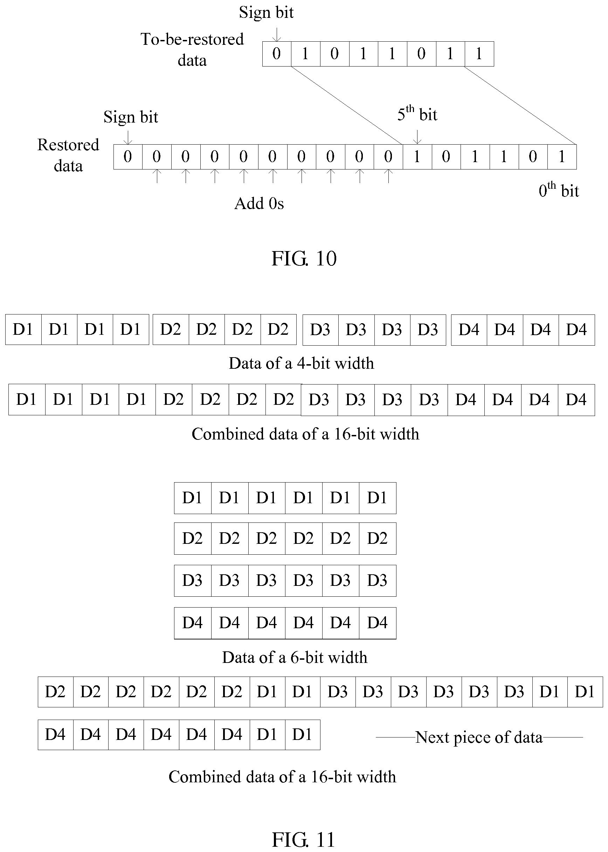

804. A case in which i is less than or equal to N-1:
When i, the quantity of bits from the nonzero most significant bit to the least significant bit in the restored data is less than or equal to N-1, the quantity of bits from the second most significant bit to the least significant bit in the to-be-restored data, determine that numerical values of i bits extracted successively from the second most significant bit to a less significant bit of the to-be-restored data are numerical values of the nonzero most significant bit to the least significant bit of the restored data. Specifically, for example, as shown in FIG. 10, a bit width of to-be-restored data 01011011 is N=8 bits, an initial bit width is 16 bits, and the bit sequence information indicates that a nonzero most significant bit of the physical-layer data is the 5th bit. That is, the quantity of bits from the nonzero most significant bit to a less significant bit in the restored data is i=6, and i is less than N-1. It may be determined that a sign bit that is a most significant bit of in a most significant bit of the to-be-restored data is a sign bit that is a most significant bit of in a most significant bit of the restored data. It may be determined that numerical values of 9 bits from the second most significant bit (the 14th bit) to a previous bit (the 6th bit) of the nonzero most significant bit of the restored data are 0; it may be determined that numerical values 101101 of 6 bits from the second most significant bit to a less significant bit of the to-be-restored data are numerical values of 6 bits from the nonzero most significant bit to the least significant bit of the restored data.

FIG. 11 is a schematic diagram of a data combination principle according to an embodiment of the present invention.

After bit width conversion in embodiments corresponding to FIG. 3 and FIG. 5 is performed on physical-layer data, because a data bit width is reduced, converted data may not fully use radio frame resources allocated by an LTE system to the physical-layer data. Therefore, data combination may be performed on the data that has undergone the bit width conversion, so as to increase a usage rate of LTE radio frame resources and thereby increase a utilization rate of entire physical-layer transmission bandwidth. An LTE physical-layer transmission resource consists of 10 ms radio frames, each radio frame consists of 10 subframes, each subframe consists of 2 timeslots, and 1 timeslot consists of 7 symbols. A smallest resource unit on a physical layer is a resource element (RE, Resource Element), which consists of one subcarrier in a frequency domain and one symbol in a time domain. Its data bit width is 8 bits. Assuming that a data bit width of the physical-layer data that has undergone the bit width conversion is 4 bits, the data in this case needs to be combined to adapt to the RE. The data may be combined in the following manners:

### 1. Combination based on an integer multiple

When a bit width in a data transmission mode on an LTE physical-layer is an integer multiple of the bit width of the physical-layer data that has undergone the bit width conversion, for example, when data of a 4-bit width needs to be combined into data of a 16-bit width, four pieces of data of a 4-bit width may be combined into one piece of data of a 16-bit width for transmission. As shown in FIG. 11, four pieces of data of a 4-bit width are combined into one piece of data of a 16-bit width. The first piece of data D1 of a 4-bit width is mapped to 4 most significant bits of the data of a 16-bit width, and the second piece of data D2 of a 4-bit width is mapped to 4 second most significant bits of the data of a 16-bit width, and so on.

### 2. Combination based on a non-integer multiple

When a bit width of an LTE physical-layer data transmission mode is not an integer multiple of the bit width of the physical-layer data that has undergone the bit width conversion, for example, when data of a 6-bit width needs to be combined into data of an 8-bit width, as shown in FIG. 11, the first piece of data D1 of a 6-bit width may be divided into three equal parts, and the three parts are added separately to less significant bits or more significant bits of subsequent three pieces of data D2, D3, and D4 of a 6-bit width (the figure shows only a case in which the parts are added to less significant bits) to form three pieces of data of an 8-bit width, which are then combined into data of a 16-bit width. The foregoing is merely an example of non-integer-multiple combination. The data may also be combined in many other manners, and the present invention is not limited thereto.

After receiving data that has undergone data combination, a receive end needs to perform data combination restoration processing to restore the data. A process thereof is reverse to the data combination process with a similar principle, and details are not described herein again.

By means of data combination, data that has undergone bit width conversion can match a physical-layer data transmission mode, time-frequency resources for physical-layer data transmission are fully utilized, and data transmission efficiency is improved.

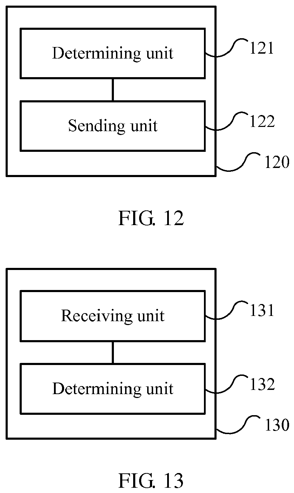

FIG. 12 is a schematic block diagram of a data transmission device according to an embodiment of the present invention. A device 120 shown in FIG. 12 includes a determining unit 121 and a sending unit 122.

It should be noted that the data transmission device provided in the embodiment of the present invention may be a base station, or may be a component of a base station, for example, may be a baseband processing unit or a radio frequency unit in a base station, or may be another apparatus that is in the base station, is independent of a baseband processing unit or a radio frequency unit, and is connected to the baseband processing unit or the radio frequency unit. Alternatively, the data transmission device may also be a centralized management device such as a central node, or a component of a centralized management device, where the centralized management device may be connected to at least one base station that provides receiving and sending functions. All functional units in the data transmission device may be deployed in a centralized manner, or may be deployed in a distributed manner inside a base station and can communicate with each other. For example, they are deployed inside a baseband processing unit or a radio frequency unit of a base station, or may be deployed in other positions in the base station and communicate with a baseband processing unit and a radio frequency unit, so as to implement the physical-layer data transmission method described in the method embodiment part of the present invention.

The determining unit 121 is configured to: determine a target bit width of physical-layer data, where the target bit width is N bits and the target bit width is less than an actual bit width of the physical-layer data; and determine to-be-transmitted data whose bit width is N bits, where numerical values of all or some of bits in the to-be-transmitted data are numerical values extracted successively from a nonzero most significant bit to a less significant bit of the physical-layer data. The sending unit 122 sends the to-be-transmitted data to a receive end.

By performing bit width conversion on physical-layer data, the device 120 in the embodiment of the present invention reduces bandwidth required for transmitting the physical-layer data, and can effectively reduce limitations imposed by limited transmission bandwidth resources on transmission of the physical-layer data inside the device, thereby enhancing user experience.

Optionally, in an embodiment, that the determining unit 121 is configured to determine to-be-transmitted data whose bit width is N bits includes: determining that a sign bit of the physical-layer data is a most significant bit of the to-be-transmitted data; and when i, a quantity of bits from the nonzero most significant bit to a least significant bit in the physical-layer data is greater than or equal to N-1, determining that numerical values of N-1 bits extracted successively from the nonzero most significant bit to a less significant bit of the physical-layer data are numerical values of a second most significant bit to a least significant bit of the to-be-transmitted data; or when i, a quantity of bits from the nonzero most significant bit to a least significant bit in the physical-layer data is less than N-1, determining that numerical values of i bits extracted successively from the nonzero most significant bit to a less significant bit of the physical-layer data are numerical values of a second most significant bit to a less significant bit of the to-be-transmitted data, and determining that numerical values of N-1-i less significant bits are 0.

That is, after the determining unit 121 determines the target bit width N into which the physical-layer data needs to be converted, the physical-layer data with an initial bit width may be converted into to-be-transmitted data whose bit width is N bits, so as to facilitate transmission. Specifically, physical-layer data generally includes a sign bit, and the sign bit that is a most significant bit of at a most significant bit of the physical-layer data may be determined as a most significant bit of the to-be-transmitted data. Then, i, the quantity of bits from the nonzero most significant bit to the least significant bit in the physical-layer data, and N-1 is compared. That is, it is necessary to determine whether a quantity of valid bits that are used for carrying data and are included in the physical-layer data is enough to implement bit width conversion with the target bit width being N bits, or in other words, to determine whether 0 needs to be added as a filler in the bit width conversion. For a specific conversion process, reference may be made to the corresponding content in the embodiment in FIG. 3, and details are not described herein again.

Optionally, in an embodiment, the determining unit 121 may be further specifically configured to: determine bit sequence information of the nonzero most significant bit of the physical-layer data, where according to the bit sequence information, i, the quantity of bits from the nonzero most significant bit to the least significant bit in the physical-layer data may be determined, where the bit sequence information is used to indicate that the nonzero most significant bit is the (i-1)th bit of the physical-layer data (a bit sequence of the physical-layer data starts with the 0th bit). For determining the bit sequence information of the nonzero most significant bit of the physical-layer data, the input physical-layer data may be temporarily stored after the input physical-layer data is received, and then data detection is performed on the physical-layer data to determine which bit is the nonzero most significant bit of the physical-layer data. Physical-layer data generally includes a sign bit. That is, the data detection is performed to detect the bits of the physical-layer data from the second most significant bit to a less significant bit of the physical-layer data, and determine a bit sequence (which bit) of a first nonzero bit that is detected. For a specific determining method, reference may be made to the corresponding content in the embodiment in FIG. 3, and details are not described herein again.

Optionally, in an embodiment, the determining unit 121 may be further specifically configured to: determine a candidate target bit width of the physical-layer data according to condition information of the physical-layer data, where the condition information is used to determine the target bit width; determine a data traffic volume of data, into which the physical-layer data is converted, with the candidate target bit width; and when the data traffic volume after the conversion into the candidate target bit width is less than a target traffic volume, determine that the candidate target bit width is the target bit width, where the target traffic volume is determined according to transmission bandwidth of the physical-layer data.

The condition information that is used to determine the target bit width includes but is not limited to one or more of the following: a modulation scheme of the physical-layer data, a quantity of antennas at a base station, a service type (such as full buffering and burst), a MIMO manner (transmit and receive diversity, multiplexing, and the like), channel measurement information (such as a channel signal-to-noise ratio and channel measurement power), a guaranteed bit width, and the like. It should be understood that the condition information considered for determining the target bit width is not limited to those enumerated above, and may further include other factors that can affect generation, transmission and parsing of the physical-layer data, which is not limited in the present invention. Optionally, before the target bit width of the physical-layer data is determined, a correspondence between one or more items of the foregoing condition information and the candidate target bit width may be preset. For example, a correspondence between the modulation scheme, the quantity of antennas, the guaranteed bit width and the candidate target bit width may be preset. Then, a corresponding candidate target bit width may be determined according to the foregoing types of condition information of the physical-layer data, where the guaranteed bit width is a minimum bit width with which the physical-layer data can be normally transmitted and parsed.

The condition information that is used to determine the target bit width includes but is not limited to one or more of the following: a modulation scheme of the physical-layer data, a quantity of antennas at a base station, a service type (such as full buffering and burst), a MIMO manner (transmit and receive diversity, multiplexing, and the like), channel measurement information (such as a channel signal-to-noise ratio and channel measurement power), a guaranteed bit width, and the like. It should be understood that the condition information considered for determining the target bit width is not limited to those enumerated above, and may further include other factors that can affect generation, transmission and parsing of the physical-layer data, which is not limited in the present invention. Optionally, before the target bit width of the physical-layer data is determined, a correspondence between one or more items of the foregoing condition information and the candidate target bit width may be preset. For example, a correspondence between the modulation scheme, the quantity of antennas, the guaranteed bit width and the candidate target bit width may be preset. Then, a corresponding candidate target bit width may be determined according to the foregoing types of condition information of the physical-layer data, where the guaranteed bit width is a minimum bit width with which the physical-layer data can be normally transmitted and parsed.

The bit width of the physical-layer data is converted dynamically by using the foregoing condition information. A data transmission rate may be adjusted dynamically according to a current data transmission condition of a system.

In addition, in view of a granularity of data bit width conversion, the target bit width may also be used as a target bit width of multiple pieces of data before and/or after the physical-layer data when the target bit width of the physical-layer data is determined. A size of the granularity may be adjusted according to a buffer depth of a bit width converting module. For example, if the buffer depth of the bit width converting module is preset to 100 pieces of data, the bit width converting module may temporarily store 100 pieces of data at a time. For any of the 100 pieces of data (physical-layer data), a target bit width may be determined according to the foregoing method, and the target bit width is used as a target bit width of the 100 pieces of data. For another example, the buffer depth of the bit width converting module may also be set to 1 piece of data, that is, a target bit width is determined for each piece of data. A finer granularity may achieve higher precision in determining the candidate target bit width and a data traffic volume, and a coarser granularity may increase a processing speed and reduce resource overhead.

After the candidate target bit width is determined elementarily, the data traffic volume after the conversion into the candidate target bit width and the target traffic volume may be compared to determine whether the candidate target bit width meets a requirement, where the target traffic volume may be a maximum data traffic volume that can be carried by a physical-layer data transmission channel, and may be determined according to a transmission bandwidth limit of the physical-layer data.

Optionally, the data traffic volume may be estimated in advance according to the candidate target bit width, so as to determine the data traffic volume of data, into which the physical-layer data is converted, with the candidate target bit width. Specifically, it may be defined that the data traffic volume is an amount of data that passes through a physical-layer data transmission channel within a period. That is, the determining of the data traffic volume may be performed only on the physical-layer data converted into the candidate target bit width, or may be performed on multiple pieces of data before and/or after the physical-layer data converted into the candidate target bit width. In addition, other data may be transmitted in parallel with the physical-layer data converted into the candidate target bit width, and the determining of the data traffic volume may be performed on both the physical-layer data converted into the candidate target bit width and parallel data thereof.

As for determining the size of the data traffic volume after the conversion into the candidate target bit width and the size of the target traffic volume, the following determining results and subsequent processing processes may exist:
Optionally, one determining result and subsequent processing process are: when the data traffic volume after the conversion into the candidate target bit width is less than the target traffic volume, it is determined that the candidate target bit width is the target bit width, where the target traffic volume is determined according to transmission bandwidth of the physical-layer data. Because the determined correspondence between the candidate target bit width and the condition information may include a guaranteed bit width, the candidate target bit width determined according to the correspondence is greater than the guaranteed bit width. That is, the current candidate target bit width meets a requirement, and may be determined as the target bit width.

Optionally, another determining result and subsequent processing process are: the candidate target bit width of the physical-layer data is reduced according to a predetermined range when the data traffic volume after the conversion into the candidate target bit width is greater than the target traffic volume; it is determined whether a data traffic volume determined according to a reduced candidate target bit width is less than the target traffic volume, and it is ensured that the reduced candidate target bit width is greater than the guaranteed bit width; and when the data traffic volume determined according to the reduced candidate target bit width is less than the target traffic volume, and the reduced candidate target bit width is greater than or equal to the guaranteed bit width, it is determined that the reduced candidate target bit width is the target bit width.

With this determining result, if bit width conversion is performed on the physical-layer data according to the candidate target bit width, the data traffic volume obtained after the conversion exceeds the maximum data traffic volume allowed by the data transmission channel (target traffic volume). Therefore, the candidate target bit width needs to be reduced. For example, during reduction of the candidate target bit width, a candidate target bit width of a low-priority user may be reduced according to a range of 1 bit that is agreed upon in advance. Then, a data traffic volume of the physical-layer data converted into a reduced candidate target bit width may be determined. That is, the data traffic volume is re-determined according to the reduced candidate target bit width, and the re-determined data traffic volume and the target traffic volume is compared. If the re-determined data traffic volume is still greater than the target traffic volume, the bit width is further reduced until a re-determined data traffic volume is less than the target traffic volume, and in this case, a current candidate target bit width may be determined as the target bit width.

If the current candidate target bit width is already reduced to the guaranteed bit width but the data traffic volume is still greater than the target traffic volume, alarm information may be sent, and another upper-layer functional unit in the base station performs further processing, for example, performs traffic suppression and resource scheduling, so as to relieve data transmission pressure on the physical-layer data transmission channel.

Optionally, still another determining result is that the data traffic volume is equal to the target traffic volume. A subsequent processing process in this case may be agreed upon in advance according to actual conditions. This determining result may be incorporated into the case in which the data traffic volume is greater than the target traffic volume, and may also be incorporated into the case in which the data traffic volume is less than the target traffic volume. Correspondingly, the subsequent processing process may be executed according to the subsequent processing process in either of the foregoing two cases as agreed upon in advance, which is not specially limited in the present invention.

Optionally, in an embodiment, the determining unit 121 may be further configured to: convert subsequent data of the physical-layer data into data whose bit width is N bits according to the target bit width and the bit sequence information. According to the granularity principle of data bit width conversion mentioned in the foregoing embodiment, the (candidate) target bit width determined for the physical-layer data may also be used as the (candidate) target bit width of multiple pieces of data before and/or after the physical-layer data. For example, the target bit width of the physical-layer data may be determined as the target bit width of subsequent 99 pieces of data. That is, the target bit width and the bit sequence information of the physical-layer data may be used as the target bit width and the bit sequence information of subsequent data for bit width conversion of subsequent data, thereby saving computing resources of the system. A quantity of pieces (that is, granularity) of subsequent data that uses the target bit width and the bit sequence information may be set according to a running status of the system. For example, when load of the system is light, the granularity may be reduced; when the load of the system is heavy, the granularity may be increased properly. A finer granularity may achieve higher precision in bit width conversion, and a coarser granularity may increase a processing speed and reduce resource overhead.

Optionally, in an embodiment, the sending unit 122 may be further configured to: send an initial bit width and the bit sequence information of the physical-layer data to a receive end, so that the receive end restores the received to-be-transmitted data to data with the initial bit width according to the bit sequence information. After the data that has undergone bit width conversion is transmitted to the receive end, bit width restoration may be performed so that the data can be parsed by the receive end correctly. Therefore, when sending the to-be-transmitted data, the device 120 may also send the initial bit width and the bit sequence information of the physical-layer data together to the receive end to facilitate bit width restoration performed at the receive end.

The device 120 in the embodiment of the present invention determines a target bit width of physical-layer data that needs to be transmitted, and transmits the physical-layer data after reducing a bit width of the physical-layer data to the target bit width, thereby reducing bandwidth required for transmitting the physical-layer data. Transmission of physical-layer data by using the technical solution provided in the embodiment of the present invention imposes a low requirement of system bandwidth performance, and can effectively reduce limitations imposed by limited transmission bandwidth resources on transmission of the physical-layer data inside a base station, which improves data transmission efficiency and enhances user experience.

In addition, the data transmission device provided in the embodiment of the present invention can determine a target bit width dynamically according to condition information, that is, adjust a data transmission rate dynamically according to a current data transmission condition of a system, thereby reducing a data rate as much as possible on a precondition of satisfying service performance requirements of the system. Further, by determining a nonzero most significant bit and determining a quantity of valid bits, as many valid bits as possible are retained when bit width conversion is performed, which can reduce data distortion caused by the bit width conversion as much as possible. In addition, by arbitrarily adjusting a granularity for processing the bit width conversion, the system can achieve, according to an actual running status, higher precision in the bit width conversion or achieve a higher processing speed and less resource overhead.

FIG. 13 is a schematic block diagram of a data transmission device according to an embodiment of the present invention. A device 130 in FIG. 13 includes a receiving unit 131 and a determining unit 132.

The receiving unit 131 receives to-be-restored data sent by a transmit end, where an actual bit width of the to-be-restored data is N bits, the to-be-restored data is data obtained from bit width conversion of physical-layer data, and numerical values of all or some of bits in the to-be-restored data are numerical values extracted successively from a nonzero most significant bit to a less significant bit of the physical-layer data; and receives an initial bit width of the physical-layer data, where the initial bit width is sent by the transmit end and is M bits, and N is less than M. The determining unit 132 determines data whose bit width is M bits, where numerical values of some of bits in the restored data are numerical values of bits extracted successively from a second most significant bit to a less significant bit of the to-be-restored data.

In the embodiment of the present invention, by converting a bit width of physical-layer data, a data rate is reduced during data transmission and bit width restoration is performed in the device 130 to restore data that has undergone the bit width conversion, which can effectively reduce limitations imposed by limited transmission bandwidth resources on transmission of physical-layer data inside the device, thereby enhancing user experience.

It should be understood that the to-be-restored data received by the device 130 and sent by the transmit end may be data obtained after the transmit end performs bit width conversion on the physical-layer data, and the bit width conversion method described in the embodiment shown in FIG. 3 may be applied. The data that has undergone bit width conversion may be referred to as to-be-transmitted data, and after being sent by the transmit end to the device 130, the to-be-transmitted data may be referred to as to-be-restored data. That is, the to-be-transmitted data and the to-be-restored data mentioned in the embodiment of the present invention may refer to the same object. The data obtained after the device 130 performs bit width restoration on the to-be-restored data may be referred to as restored data. The restored data includes valid data, and numerical values of the valid data are the same as numerical values of some of bits of the to-be-restored data. It is easy to understand that the restored data may be not completely the same as the physical-layer data because the data has undergone two processing processes, that is, bit width conversion and bit width restoration.

Optionally, in an embodiment, that the determining unit 132 is configured to determine restored data whose bit width is M bits includes: determining that a sign bit of the to-be-restored data is a most significant bit of the data; and when i, a quantity of bits from the nonzero most significant bit to a least significant bit in the data, is greater than N-1, a quantity of bits from the second most significant bit to a least significant bit in the restored data, determining that numerical values of N-1 bits extracted successively from the second most significant bit to a less significant bit of the restored data are numerical values of the nonzero most significant bit to a less significant bit of the data, and determining that numerical values of i-(N-1) less significant bits are 0; when i, a quantity of bits from the nonzero most significant bit to a least significant bit in the data, is less than or equal to N-1, a quantity of bits from the second most significant bit to a least significant bit in the restored data, determining that numerical values of i bits extracted successively from the second most significant bit to a less significant bit of the to-be-restored data are numerical values of the nonzero most significant bit to the least significant bit of the data. For a specific example, reference may be made to corresponding examples in the embodiment in FIG. 4, and details are not described herein again.

So far, in a subsequent bit width restoration process for the foregoing two determining results, the numerical values of the most significant bit and the bits from the nonzero most significant bit to the least significant bit of the restored data are determined, and it may be determined that numerical values of bits from the most significant bit (sign bit) to the nonzero most significant bit are 0, so as to complete the entire bit width restoration process and obtain the restored data whose bit width is M bits.

Optionally, in an embodiment, the determining unit 132 is further configured to: determine i, a quantity of bits from the nonzero most significant bit to a least significant bit in the data according to bit sequence information of the nonzero most significant bit of the physical-layer data, where the bit sequence information is used to indicate that the nonzero most significant bit is the (i-1)th bit of the data, so that the restored data whose bit width is M bits includes i bits of valid data, where numerical values of the valid data are the numerical values of the bits extracted successively from the second most significant bit to the less significant bit of the to-be-restored data. Specifically, when performing bit width conversion on the physical-layer data, the transmit end may determine the bit sequence information of the nonzero most significant bit of the physical-layer data. For a detailed method for determining the bit sequence information, reference may be made to the related description in the embodiment shown in FIG. 3, and details are not described herein again.

Optionally, in an embodiment, the determining unit 132 is further configured to: convert subsequent data of the to-be-restored data into data whose bit width is M bits according to the target bit width and the bit sequence information. That is, the target bit width and the bit sequence information of the physical-layer data may be used as a target bit width and bit sequence information of subsequent to-be-restored data for performing bit width restoration on the subsequent to-be-restored data. A quantity of pieces of subsequent to-be-restored data that uses the target bit width and the bit sequence information may be set. For example, it is set that 99 pieces of subsequent to-be-restored data share the target bit width and the bit sequence information to for performing bit width restoration. A granularity of data bit width restoration may be adjusted arbitrarily. A finer granularity may achieve higher precision in bit width restoration, and a coarser granularity may increase a processing speed and reduce resource overhead. The granularity may be adjusted by means of a buffer depth. For a detailed description of the granularity, reference may be made to the related content in the embodiment shown in FIG. 3, and details are not described herein again.

In addition, in an optional embodiment, after receiving the to-be-restored data sent by the transmit end, the device 130 may not perform bit width restoration on the to-be-restored data according to an initial bit width M, but the device 130 may, according to a system running status, service requirements, or the like, independently determine a bit width to which the to-be-restored data is to be restored, so as to facilitate bit width restoration.

By performing bit width conversion on physical-layer data, the data transmission device provided in the embodiment of the present invention reduces a data rate during data transmission, and bit width restoration is performed to restore data that has undergone the bit width conversion, which can effectively reduce limitations imposed by limited transmission bandwidth resources on transmission of physical-layer data inside a base station, thereby enhancing user experience.

Further, by determining a nonzero most significant bit and determining a quantity of valid bits, the data transmission device provided in the embodiment of the present invention retains as many valid bits as possible when performing bit width restoration, which can restore physical-layer data that has undergone bit width conversion and reduce data distortion as much as possible. In addition, by arbitrarily adjusting a granularity for processing bit width restoration, higher precision or a higher processing speed and less resource overhead can be achieved according to actual conditions.

It should be understood that all functional units of the device 120 in FIG. 12 and the device 130 in FIG. 13 may be integrated into one data transmission device, and the data transmission device may have a bit width conversion function, a bit width restoration function, and a data transmitting and receiving function at the same time.

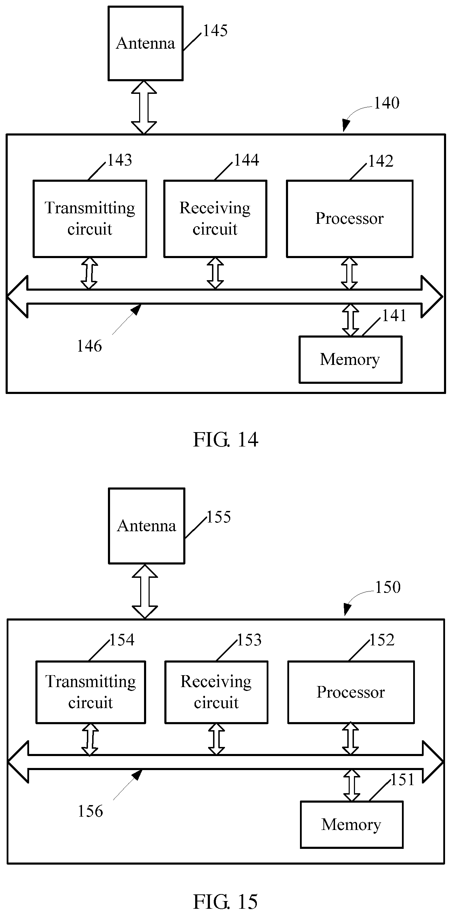

FIG. 14 is a schematic block diagram of a data transmission device according to another embodiment of the present invention. A device 140 in FIG. 14 includes a memory 141, a processor 142, and a transmitting circuit 143.

The memory 141 stores instructions that instruct the processor 142 to perform the following operations: determining a target bit width of physical-layer data, where the target bit width is N bits and the target bit width is less than an actual bit width of the physical-layer data; determining to-be-transmitted data whose bit width is N bits, where numerical values of all or some of bits in the to-be-transmitted data are numerical values extracted successively from a nonzero most significant bit to a less significant bit of the physical-layer data; and using the transmitting circuit 143 to send the to-be-transmitted data to a receive end.

By performing bit width conversion on physical-layer data, the device 140 in the embodiment of the present invention reduces bandwidth required for transmitting the physical-layer data, and can effectively reduce limitations imposed by limited transmission bandwidth resources on transmission of the physical-layer data inside the device, thereby enhancing user experience.

In addition, the device 140 may further include a receiving circuit 144, an antenna 145, and the like. The processor 142 controls an operation of the device 140, and the processor 142 may also be referred to as a CPU (Central Processing Unit, central processing unit). The memory 141 may include a read-only memory and a random access memory, and provide an instruction and data for the processor 142. A part of the memory 141 may further include a non-volatile random access memory (NVRAM). In a specific application, the transmitting circuit 143 and the receiving circuit 144 may be coupled to the antenna 145. All components of the device 140 are coupled together by using a bus system 146, where the bus system 146 includes not only a data bus but also a power supply bus, a control bus, a status signal bus, and the like. However, for clear description, various buses in the diagram are marked as the bus system 146.

The method disclosed in the embodiment of the present invention may be applied to the processor 142 or may be implemented by the processor 142. The processor 142 may be an integrated circuit chip with a signal processing capability. In an implementation process, steps of the foregoing method may be implemented by using an integrated logical circuit in a hardware form or instructions in a software form in the processor 142. The processor 142 may be a general purpose processor, a digital signal processor (DSP), an application-specific integrated circuit (ASIC), a field programmable gate array (FPGA) or another programmable logical device, a discrete gate or transistor logical device, or a discrete hardware component, and can implement or execute all methods, steps and logical block diagrams disclosed in the embodiments of the present invention. The general purpose processor may be a microprocessor, or the processor may be any conventional processor or the like. The steps of the methods disclosed with reference to the embodiments of the present invention may be directly performed and completed by a decoding processor, or may be performed and completed by a combination of hardware and a software module in a decoding processor. The software module may be located in a storage medium that is mature in the art, such as a random access memory, a flash memory, a read-only memory, a programmable read-only memory, an electrically erasable programmable memory, or a register. The storage medium is located in the memory 141, and the processor 142 reads information in the memory 141 and completes the steps of the foregoing methods by using its hardware.

Optionally, in an embodiment, that the device 140 determines to-be-transmitted data whose bit width is N bits includes: determining that a sign bit of the physical-layer data is a most significant bit of the to-be-transmitted data; when i, a quantity of bits from the nonzero most significant bit to a least significant bit in the physical-layer data is greater than or equal to N-1, determining that numerical values of N-1 bits extracted successively from the nonzero most significant bit to a less significant bit of the physical-layer data are numerical values of a second most significant bit to a least significant bit of the to-be-transmitted data; or when i, a quantity of bits from the nonzero most significant bit to a least significant bit in the physical-layer data is less than N-1, determining that numerical values of i bits extracted successively from the nonzero most significant bit to a less significant bit of the physical-layer data are numerical values of a second most significant bit to a less significant bit of the to-be-transmitted data, and determining that numerical values of N-1-i less significant bits are 0.

Optionally, in an embodiment, after the device 140 determines the to-be-transmitted data whose bit width is N bits, the following step is further included: converting, according to a location of the nonzero most significant bit of the physical-layer data, subsequent data of the physical-layer data into data whose bit width is N bits, where numerical values of all or some of bits in the data whose bit width is N bits are numerical values of bits extracted from the subsequent data.

Optionally, in an embodiment, before the device 140 determines the to-be-transmitted data whose bit width is N bits, the following step is further included: determining bit sequence information of the nonzero most significant bit of the physical-layer data, where the bit sequence information is used to indicate that the nonzero most significant bit of the physical-layer data is the (i-1)th bit of the physical-layer data.

Optionally, in an embodiment, after the device 140 determines the to-be-transmitted data whose bit width is N bits, the following step is further included: converting, according to the bit sequence information, subsequent data of the physical-layer data into data whose bit width is N bits, where numerical values of all or some of bits in the data whose bit width is N bits are numerical values of bits extracted from the subsequent data.

Optionally, in an embodiment, that the device 140 determines a target bit width of physical-layer data includes: determining, according to a correspondence between preset condition information and a candidate target bit width, that a candidate target bit width corresponding to condition information of the physical-layer data is a candidate target bit width of the physical-layer data; determining a data traffic volume of data, into which the physical-layer data is converted, with the candidate target bit width; and determining, when the data traffic volume is less than a target traffic volume, that the candidate target bit width is the target bit width, where the target traffic volume is less than or equal to a maximum data traffic volume allowed by a transmission channel of the physical-layer data.

Optionally, in an embodiment, after the determining a data traffic volume of data, into which the physical-layer data is converted, with the candidate target bit width, the following step is further included: reducing the candidate target bit width of the physical-layer data according to a predetermined range when the data traffic volume is greater than the target traffic volume; and when a data traffic volume of data, into which the physical-layer data is converted, with a reduced candidate target bit width is less than the target traffic volume, and when the reduced candidate target bit width is greater than or equal to a guaranteed bit width, determining that the reduced candidate target bit width is the target bit width, where the guaranteed bit width is a minimum bit width with which the physical-layer data can be normally transmitted and parsed.

Optionally, in an embodiment, after the determining to-be-transmitted data whose bit width is N bits, the following step is further included: sending an initial bit width and bit sequence information of the physical-layer data to a peer end.

Optionally, in an embodiment, the condition information includes at least one of the following: a modulation scheme, a quantity of antennas, a MIMO manner, and channel measurement information.

The device 140 in the embodiment of the present invention determines a target bit width of physical-layer data that needs to be transmitted, and transmits the physical-layer data after reducing a bit width of the physical-layer data to the target bit width, thereby reducing bandwidth required for transmitting the physical-layer data. Transmission of physical-layer data by using the technical solution provided in the embodiment of the present invention imposes a low requirement of system bandwidth performance, and can effectively reduce limitations imposed by limited transmission bandwidth resources on transmission of the physical-layer data inside a base station, which improves data transmission efficiency and enhances user experience.

In addition, the data transmission device provided in the embodiment of the present invention can determine a target bit width dynamically according to condition information, that is, adjust a data transmission rate dynamically according to a current data transmission condition of a system, thereby reducing a data rate as much as possible on a precondition of satisfying service performance requirements of the system. Further, by determining a nonzero most significant bit and determining a quantity of valid bits, as many valid bits as possible are retained when bit width conversion is performed, which can reduce data distortion caused by the bit width conversion as much as possible. In addition, by arbitrarily adjusting a granularity for processing the bit width conversion, the system can achieve, according to an actual running status, higher precision in the bit width conversion or achieve a higher processing speed and less resource overhead.

FIG. 15 is a schematic block diagram of a data transmission device according to another embodiment of the present invention. A device 150 in FIG. 15 includes a memory 151, a processor 152, and a receiving circuit 153.

The memory 151 stores instructions that instruct the processor 152 to perform the following operations: receiving, by using a receiving circuit 153, to-be-restored data sent by a transmit end, where an actual bit width of the to-be-restored data is N bits, the to-be-restored data is data obtained from bit width conversion of physical-layer data, and numerical values of all or some of bits in the to-be-restored data are numerical values extracted successively from a nonzero most significant bit to a less significant bit of the physical-layer data; receiving, by using the receiving circuit 153, an initial bit width of the physical-layer data, where the initial bit width is sent by the transmit end and is M bits, and N is less than M; and determining restored data whose bit width is M bits, where numerical values of some of bits in the restored data are numerical values of bits extracted successively from a second most significant bit to a less significant bit of the to-be-restored data.

By performing bit width conversion on physical-layer data, the device 150 in the embodiment of the present invention reduces a data rate, and can effectively reduce limitations imposed by limited transmission bandwidth resources on transmission of the physical-layer data inside the device, thereby enhancing user experience.

In addition, the device 150 may further include a transmitting circuit 154 and the like. The processor 152 controls an operation of the device 150, and the processor 152 may also be referred to as a CPU (Central Processing Unit, central processing unit). The memory 151 may include a read-only memory and a random access memory, and provide an instruction and data for the processor 152. A part of the memory 151 may further include a non-volatile random access memory (NVRAM). In a specific application, the transmitting circuit 154 and the receiving circuit 153 may be coupled to an antenna 155. All components of the device 150 are coupled together by using a bus system 156, where the bus system 156 includes not only a data bus but also a power supply bus, a control bus, a status signal bus, and the like. However, for clear description, various buses in the diagram are marked as one bus system 156.

The method disclosed in the embodiment of the present invention may be applied to the processor 152 or may be implemented by the processor 152. The processor 152 may be an integrated circuit chip with a signal processing capability. In an implementation process, steps of the foregoing method may be implemented by using an integrated logical circuit in a hardware form or instructions in a software form in the processor 152. The processor 152 may be a general purpose processor, a digital signal processor (DSP), an application-specific integrated circuit (ASIC), a field programmable gate array (FPGA) or another programmable logical device, a discrete gate or transistor logical device, or a discrete hardware component, and can implement or execute all methods, steps and logical block diagrams disclosed in the embodiments of the present invention. The general purpose processor may be a microprocessor, or the processor may be any conventional processor or the like. The steps of the methods disclosed with reference to the embodiments of the present invention may be directly performed and completed by a decoding processor, or may be performed and completed by a combination of hardware and a software module in a decoding processor. The software module may be located in a storage medium that is mature in the art, such as a random access memory, a flash memory, a read-only memory, a programmable read-only memory, an electrically erasable programmable memory, or a register. The storage medium is located in the memory 151, and the processor 152 reads information in the memory 151 and completes the steps of the foregoing methods by using its hardware.

Optionally, in an embodiment, before the device 150 determines the restored data whose bit width is M bits, the following step is further included: receiving bit sequence information of the physical-layer data, where the bit sequence information is sent by the transmit end and is used to indicate that the nonzero most significant bit of the physical-layer data is the (i-1)th bit of the physical-layer data; and according to the bit sequence information, determining i, a quantity of bits from a nonzero most significant bit to a least significant bit in the restored data, so that the restored data whose bit width is M bits includes i bits of valid data, where numerical values of the valid data are the numerical values of the bits extracted successively from the second most significant bit to the less significant bit of the to-be-restored data.

Optionally, in an embodiment, before the device 150 determines the restored data whose bit width is M bits, the following step is further included: determining i, a quantity of bits from a nonzero most significant bit to a least significant bit in the restored data, so that the restored data whose bit width is M bits includes i bits of valid data, where numerical values of the valid data are the numerical values of the bits extracted successively from the second most significant bit to the less significant bit of the to-be-restored data.

Optionally, in an embodiment, that the device 150 determines the restored data whose bit width is M bits includes: determining that a sign bit of the to-be-restored data is a most significant bit of the restored data; and when i, the quantity of bits from the nonzero most significant bit to the least significant bit in the restored data, is greater than N-1, a quantity of bits from the second most significant bit to a least significant bit in the to-be-restored data, determining that numerical values of N-1 bits extracted successively from the second most significant bit to a less significant bit of the to-be-restored data are numerical values of the nonzero most significant bit to a less significant bit of the restored data, and determining that numerical values of i-(N-1) less significant bits are 0; when i, the quantity of bits from the nonzero most significant bit to the least significant bit in the restored data, is less than or equal to N-1, a quantity of bits from the second most significant bit to a least significant bit in the to-be-restored data, determining that numerical values of i bits extracted successively from the second most significant bit to a less significant bit of the to-be-restored data are numerical values of the nonzero most significant bit to the least significant bit of the restored data.

Optionally, in an embodiment, after the determining that a sign bit of the to-be-restored data is a most significant bit of the restored data, the following step is further included: determining that numerical values of bits from the most significant bit to the nonzero most significant bit of the restored data are 0.

Optionally, in an embodiment, after the device 150 determines the restored data whose bit width is M bits, the following step is further included: according to the initial bit width and the bit sequence information, converting subsequent data of the to-be-restored data into data whose bit width is M bits, where numerical values of some of bits in the data whose bit width is M bits are numerical values of bits extracted successively from a second most significant bit to a less significant bit of the subsequent data.

By performing bit width conversion on physical-layer data, the data transmission device provided in the embodiment of the present invention reduces a data rate during data transmission, and bit width restoration is performed to restore data that has undergone the bit width conversion, which can effectively reduce limitations imposed by limited transmission bandwidth resources on transmission of physical-layer data inside a base station, thereby enhancing user experience.

Further, by determining a nonzero most significant bit and determining a quantity of valid bits, the data transmission device provided in the embodiment of the present invention retains as many valid bits as possible when performing bit width restoration, which can restore physical-layer data that has undergone bit width conversion and reduce data distortion as much as possible. In addition, by arbitrarily adjusting a granularity for processing bit width restoration, higher precision or a higher processing speed and less resource overhead can be achieved according to actual conditions.

It should be understood that all functional units of the device 140 in FIG. 14 and the device 150 in FIG. 15 may be integrated into one data transmission device, and the data transmission device may have a bit width conversion function, a bit width restoration function, and a data transmitting and receiving function at the same time.

It should be understood that the technical solutions provided in the present invention are a general technical idea. A correspondence exists between steps in a method embodiment and apparatus embodiments, and mutual reference may be made between them. For functions of and method steps performed by units or devices in the apparatus embodiment part, reference may be made to the related content in the method embodiments in FIG. 2 to FIG. 11, and no repeated description is given.

It should be understood that sequence numbers of the foregoing processes do not mean execution sequences in various embodiments of the present invention. The execution sequences of the processes should be determined according to functions and internal logic of the processes, and should not be construed as any limitation on the implementation processes of the embodiments of the present invention.

A person of ordinary skill in the art may be aware that, in combination with the examples described in the embodiments disclosed in this specification, units and algorithm steps may be implemented by electronic hardware or a combination of computer software and electronic hardware. Whether the functions are performed by hardware or software depends on particular applications and design constraint conditions of the technical solutions. A person skilled in the art may use different methods to implement the described functions for each particular application, but it should not be considered that the implementation goes beyond the scope of the present invention.

It may be clearly understood by a person skilled in the art that, for the purpose of convenient and brief description, for a detailed working process of the foregoing system, apparatus, and unit, reference may be made to a corresponding process in the foregoing method embodiments, and details are not described herein again.

In the several embodiments provided in the present application, it should be understood that the disclosed system, apparatus, and method may be implemented in other manners. For example, the described apparatus embodiment is merely exemplary. For example, the unit division is merely logical function division and may be other division in actual implementation. For example, a plurality of units or components may be combined or integrated into another system, or some features may be ignored or not performed. In addition, the displayed or discussed mutual couplings or direct couplings or communication connections may be implemented through some interfaces. The indirect couplings or communication connections between the apparatuses or units may be implemented in electronic, mechanical, or other forms.

The units described as separate parts may or may not be physically separate, and parts displayed as units may or may not be physical units, may be located in one position, or may be distributed on a plurality of network units. Some or all of the units may be selected according to actual needs to achieve the objectives of the solutions of the embodiments.

In addition, functional units in the embodiments of the present invention may be integrated into one processing unit, or each of the units may exist alone physically, or two or more units are integrated into one unit.

When the functions are implemented in the form of a software functional unit and sold or used as an independent product, the functions may be stored in a computer-readable storage medium. Based on such an understanding, the technical solutions of the present invention essentially, or the part contributing to the prior art, or some of the technical solutions may be implemented in a form of a software product. The software product is stored in a storage medium, and includes several instructions for instructing a computer device (which may be a personal computer, a server, or a network device) to perform all or some of the steps of the methods described in the embodiments of the present invention. The foregoing storage medium includes: any medium that can store program code, such as a USB flash drive, a removable hard disk, a read-only memory (ROM, Read-Only Memory), a random access memory (RAM, Random Access Memory), a magnetic disk, or an optical disc.

The foregoing descriptions are merely specific implementation manners of the present invention, but are not intended to limit the protection scope of the present invention. Any variation or replacement readily figured out by a person skilled in the art within the technical scope disclosed in the present invention shall fall within the protection scope of the present invention. Therefore, the protection scope of the present invention shall be subject to the protection scope of the claims.

## Claims

1. A data transmission device, comprising:
a determining unit, configured to determine a target bit width of physical-layer data, wherein the target bit width is N bits and the target bit width is less than an actual bit width of the physical-layer data, wherein
the determining unit is further configured to determine to-be-transmitted data whose bit width is N bits, wherein numerical values of all or some of bits in the to-be-transmitted data are numerical values extracted successively from a nonzero most significant bit to a less significant bit of the physical-layer data; and
a sending unit, configured to send the to-be-transmitted data to a receive end.

2. The device according to claim 1, wherein that the determining unit is configured to determine to-be-transmitted data whose bit width is N bits comprises:
determining that a sign bit of the physical-layer data is a most significant bit of the to-be-transmitted data; and
when i, a quantity of bits from the nonzero most significant bit to a least significant bit in the physical-layer data is greater than or equal to N-1, determining that numerical values of N-1 bits extracted successively from the nonzero most significant bit to a less significant bit of the physical-layer data are numerical values of a second most significant bit to a least significant bit of the to-be-transmitted data; or
when i, a quantity of bits from the nonzero most significant bit to a least significant bit in the physical-layer data is less than N-1, determining that numerical values of i bits extracted successively from the nonzero most significant bit to a less significant bit of the physical-layer data are numerical values of a second most significant bit to a less significant bit of the to-be-transmitted data, and determining that numerical values of N-1-i less significant bits are 0.

3. The device according to claim 2, wherein the determining unit is further configured to convert, according to a location of the nonzero most significant bit of the physical-layer data, subsequent data of the physical-layer data into data whose bit width is N bits, wherein numerical values of all or some of bits in the data whose bit width is N bits are numerical values of bits extracted from the subsequent data.

4. The device according to claim 2, wherein the determining unit is further configured to determine bit sequence information of the nonzero most significant bit of the physical-layer data, wherein the bit sequence information is used to indicate that the nonzero most significant bit of the physical-layer data is the (i-1)^{th} bit of the physical-layer data.

5. The device according to claim 4, wherein the determining unit is further configured to convert, according to the bit sequence information, subsequent data of the physical-layer data into data whose bit width is N bits, wherein numerical values of all or some of bits in the data whose bit width is N bits are numerical values of bits extracted from the subsequent data.

6. The device according to any one of claims 1 to 5, wherein that the determining unit is configured to determine a target bit width of physical-layer data comprises:
determining, according to a correspondence between preset condition information and a candidate target bit width, that a candidate target bit width corresponding to condition information of the physical-layer data is a candidate target bit width of the physical-layer data;
determining a data traffic volume of data, into which the physical-layer data is converted, with the candidate target bit width; and
determining, when the data traffic volume is less than a target traffic volume, that the candidate target bit width is the target bit width, wherein the target traffic volume is less than or equal to a maximum data traffic volume allowed by a transmission channel of the physical-layer data.

7. The device according to claim 6, wherein the determining unit is further configured to:
reduce the candidate target bit width of the physical-layer data according to a predetermined width when the data traffic volume is greater than the target traffic volume; and
when a data traffic volume of data, into which the physical-layer data is converted, with a reduced candidate target bit width is less than the target traffic volume, and when the reduced candidate target bit width is greater than or equal to a guaranteed bit width, determine that the reduced candidate target bit width is the target bit width, wherein the guaranteed bit width is a minimum bit width with which the physical-layer data can be normally transmitted and parsed.

8. The device according to claim 4, wherein the sending unit is further configured to send an initial bit width and the bit sequence information of the physical-layer data to a peer end.

9. The device according to claim 6, wherein the condition information comprises at least one of the following:
a modulation scheme;
a quantity of antennas;
a MIMO manner; and
channel measurement information.

10. A data transmission device, comprising:
a receiving unit, configured to receive to-be-restored data sent by a transmit end, wherein an actual bit width of the to-be-restored data is N bits, the to-be-restored data is data obtained from bit width conversion of physical-layer data, and numerical values of all or some of bits in the to-be-restored data are numerical values extracted successively from a nonzero most significant bit to a less significant bit of the physical-layer data, wherein
the receiving unit is further configured to receive an initial bit width of the physical-layer data, wherein the initial bit width is sent by the transmit end and is M bits, and N is less than M; and
a determining unit, configured to determine restored data whose bit width is M bits, wherein numerical values of some of bits in the restored data are numerical values of bits extracted successively from a second most significant bit to a less significant bit of the to-be-restored data.

11. The device according to claim 10, wherein the determining unit is further configured to:
receive bit sequence information of the physical-layer data by using the receiving unit, wherein the bit sequence information is sent by the transmit end and is used to indicate that the nonzero most significant bit of the physical-layer data is the (i-1)^{th} bit of the physical-layer data; and
according to the bit sequence information, determine i, a quantity of bits from a nonzero most significant bit to a least significant bit in the restored data, so that the restored data whose bit width is M bits comprises i bits of valid data, wherein numerical values of the valid data are the numerical values of the bits extracted successively from the second most significant bit to the less significant bit of the to-be-restored data.

12. The device according to claim 10, wherein the determining unit is further configured to determine i, a quantity of bits from a nonzero most significant bit to a least significant bit in the restored data, so that the restored data whose bit width is M bits comprises i bits of valid data, wherein numerical values of the valid data are the numerical values of the bits extracted successively from the second most significant bit to the less significant bit of the to-be-restored data.

13. The device according to claim 11 or 12, wherein that a determining unit is configured to determine restored data whose bit width is M bits comprises:
determining that a sign bit of the to-be-restored data is a most significant bit of the restored data; and
when i, the quantity of bits from the nonzero most significant bit to the least significant bit in the restored data, is greater than N-1, a quantity of bits from the second most significant bit to a least significant bit in the to-be-restored data, determining that numerical values of N-1 bits extracted successively from the second most significant bit to a less significant bit of the to-be-restored data are numerical values of the nonzero most significant bit to a less significant bit of the restored data, and determining that numerical values of i-(N-1) less significant bits are 0; or
when i, the quantity of bits from the nonzero most significant bit to the least significant bit in the restored data, is less than or equal to N-1, a quantity of bits from the second most significant bit to a least significant bit in the to-be-restored data, determining that numerical values of i bits extracted successively from the second most significant bit to a less significant bit of the to-be-restored data are numerical values of the nonzero most significant bit to the least significant bit of the restored data.

14. The device according to claim 13, wherein the determining unit is further configured to determine that numerical values of bits from the most significant bit to the nonzero most significant bit of the restored data are 0.

15. The device according to any one of claims 11 to 14, wherein the determining unit is further configured to convert, according to the initial bit width and the bit sequence information, subsequent data of the to-be-restored data into data whose bit width is M bits, wherein numerical values of some of bits in the data whose bit width is M bits are numerical values of bits extracted successively from a second most significant bit to a less significant bit of the subsequent data.

16. A physical-layer data transmission method, comprising:
determining, by a transmit end, a target bit width of physical-layer data, wherein the target bit width is N bits and the target bit width is less than an actual bit width of the physical-layer data;
determining, by the transmit end, to-be-transmitted data whose bit width is N bits, wherein numerical values of all or some of bits in the to-be-transmitted data are numerical values extracted successively from a nonzero most significant bit to a less significant bit of the physical-layer data; and
sending, by the transmit end, the to-be-transmitted data to a receive end.

17. The method according to claim 16, wherein the determining, by the transmit end, to-be-transmitted data whose bit width is N bits comprises:
determining that a sign bit of the physical-layer data is a most significant bit of the to-be-transmitted data; and
when i, a quantity of bits from the nonzero most significant bit to a least significant bit in the physical-layer data is greater than or equal to N-1, determining that numerical values of N-1 bits extracted successively from the nonzero most significant bit to a less significant bit of the physical-layer data are numerical values of a second most significant bit to a least significant bit of the to-be-transmitted data; or
when i, a quantity of bits from the nonzero most significant bit to a least significant bit in the physical-layer data is less than N-1, determining that numerical values of i bits extracted successively from the nonzero most significant bit to a less significant bit of the physical-layer data are numerical values of a second most significant bit to a less significant bit of the to-be-transmitted data, and determining that numerical values of N-1-i less significant bits are 0.

18. The method according to claim 17, after the determining, by the transmit end, to-be-transmitted data whose bit width is N bits, further comprising: converting, according to a location of the nonzero most significant bit of the physical-layer data, subsequent data of the physical-layer data into data whose bit width is N bits, wherein numerical values of all or some of bits in the data whose bit width is N bits are numerical values of bits extracted from the subsequent data.

19. The method according to claim 17, before the determining, by the transmit end, to-be-transmitted data whose bit width is N bits, further comprising: determining bit sequence information of the nonzero most significant bit of the physical-layer data, wherein the bit sequence information is used to indicate that the nonzero most significant bit of the physical-layer data is the (i-1)^{th} bit of the physical-layer data.

20. The method according to claim 19, after the determining, by the transmit end, to-be-transmitted data whose bit width is N bits, further comprising: converting, according to the bit sequence information, subsequent data of the physical-layer data into data whose bit width is N bits, wherein numerical values of all or some of bits in the data whose bit width is N bits are numerical values of bits extracted from the subsequent data.

21. The method according to any one of claims 16 to 20, wherein the determining, by a transmit end, a target bit width of physical-layer data comprises:
determining, according to a correspondence between preset condition information and a candidate target bit width, that a candidate target bit width corresponding to condition information of the physical-layer data is a candidate target bit width of the physical-layer data;
determining a data traffic volume of data, into which the physical-layer data is converted, with the candidate target bit width; and
determining, when the data traffic volume is less than a target traffic volume, that the candidate target bit width is the target bit width, wherein the target traffic volume is less than or equal to a maximum data traffic volume allowed by a transmission channel of the physical-layer data.

22. The method according to claim 21, after the determining a data traffic volume of data, into which the physical-layer data is converted, with the candidate target bit width, further comprising:
reducing the candidate target bit width of the physical-layer data according to a predetermined width when the data traffic volume is greater than the target traffic volume; and
when a data traffic volume of data, into which the physical-layer data is converted, with a reduced candidate target bit width is less than the target traffic volume, and when the reduced candidate target bit width is greater than or equal to a guaranteed bit width, determining that the reduced candidate target bit width is the target bit width, wherein the guaranteed bit width is a minimum bit width with which the physical-layer data can be normally transmitted and parsed.

23. The method according to claim 19, after the determining to-be-transmitted data whose bit width is N bits, further comprising: sending an initial bit width and the bit sequence information of the physical-layer data to a peer end.

24. The method according to claim 21, wherein the condition information comprises at least one of the following:
a modulation scheme;
a quantity of antennas;
a MIMO manner; and
channel measurement information.

25. A physical-layer data transmission method, comprising:
receiving, by a receive end, to-be-restored data sent by a transmit end, wherein an actual bit width of the to-be-restored data is N bits, the to-be-restored data is data obtained from bit width conversion of physical-layer data, and numerical values of all or some of bits in the to-be-restored data are numerical values extracted successively from a nonzero most significant bit to a less significant bit of the physical-layer data;
receiving, by the receive end, an initial bit width of the physical-layer data, wherein the initial bit width is sent by the transmit end and is M bits, and N is less than M; and
determining, by the receive end, restored data whose bit width is M bits, wherein numerical values of some of bits in the restored data are numerical values of bits extracted successively from a second most significant bit to a less significant bit of the to-be-restored data.

26. The method according to claim 25, before the determining, by the receive end, restored data whose bit width is M bits, further comprising:
receiving bit sequence information of the physical-layer data, wherein the bit sequence information is sent by the transmit end and is used to indicate that the nonzero most significant bit of the physical-layer data is the (i-1)^{th} bit of the physical-layer data; and
according to the bit sequence information, determining i, a quantity of bits from a nonzero most significant bit to a least significant bit in the restored data, so that the restored data whose bit width is M bits comprises i bits of valid data, wherein numerical values of the valid data are the numerical values of the bits extracted successively from the second most significant bit to the less significant bit of the to-be-restored data.

27. The method according to claim 25, before the determining, by the receive end, restored data whose bit width is M bits, further comprising: determining i, a quantity of bits from a nonzero most significant bit to a least significant bit in the restored data, so that the restored data whose bit width is M bits comprises i bits of valid data, wherein numerical values of the valid data are the numerical values of the bits extracted successively from the second most significant bit to the less significant bit of the to-be-restored data.

28. The method according to claim 26 or 27, wherein the determining, by the receive end, restored data whose bit width is M bits comprises:
determining that a sign bit of the to-be-restored data is a most significant bit of the restored data; and
when i, the quantity of bits from the nonzero most significant bit to the least significant bit in the restored data, is greater than N-1, a quantity of bits from the second most significant bit to a least significant bit in the to-be-restored data, determining that numerical values of N-1 bits extracted successively from the second most significant bit to a less significant bit of the to-be-restored data are numerical values of the nonzero most significant bit to a less significant bit of the restored data, and determining that numerical values of i-(N-1) less significant bits are 0; or
when i, the quantity of bits from the nonzero most significant bit to the least significant bit in the restored data, is less than or equal to N-1, a quantity of bits from the second most significant bit to a least significant bit in the to-be-restored data, determining that numerical values of i bits extracted successively from the second most significant bit to a less significant bit of the to-be-restored data are numerical values of the nonzero most significant bit to the least significant bit of the restored data.

29. The method according to claim 28, after the determining that a sign bit of the to-be-restored data is a most significant bit of the restored data, further comprising:
determining that numerical values of bits from the most significant bit to the nonzero most significant bit of the restored data are 0.

30. The method according to any one of claims 26 to 29, after the determining, by the receive end, restored data whose bit width is M bits, further comprising: converting, according to the initial bit width and the bit sequence information, subsequent data of the to-be-restored data into data whose bit width is M bits, wherein numerical values of some of bits in the data whose bit width is M bits are numerical values of bits extracted successively from a second most significant bit to a less significant bit of the subsequent data.
